(19)

**Europäisches Patentamt**
**European Patent Office**
**Office européen des brevets**

(11) **EP 2 427 937 B1**

(12) **EUROPÄISCHE PATENTSCHRIFT**

(45) Veröffentlichungstag und Bekanntmachung des Hinweises auf die Patenterteilung:
**26.09.2018   Patentblatt 2018/39**

(51) Int Cl.:
*H01S 5/12* (2006.01)          *H01S 5/20* (2006.01)
*H01S 5/22* (2006.01)          *H01S 5/10* (2006.01)

(21) Anmeldenummer: **10715901.4**

(22) Anmeldetag: **05.05.2010**

(86) Internationale Anmeldenummer:
**PCT/EP2010/056096**

(87) Internationale Veröffentlichungsnummer:
**WO 2010/128077 (11.11.2010 Gazette 2010/45)**

(54) **DFB LASERDIODE MIT LATERALER KOPPLUNG FÜR GROSSE AUSGANGSLEISTUNGEN**

HIGH OUTPUT DFB LASERDIODE WITH LATERAL COUPLING

DIODE LASER HAUTE PUISSANCE À RÉACTION DISTRIBUÉE AVEC COUPLAGE LATERAL

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **05.05.2009   DE 102009019996**

(43) Veröffentlichungstag der Anmeldung:
**14.03.2012   Patentblatt 2012/11**

(73) Patentinhaber: **nanoplus Nanosystems and Technologies GmbH**
**97218 Gerbrunn (DE)**

(72) Erfinder:
• **KOETH, Johannes**
**97218 Gerbrunn (DE)**
• **ZELLER, Wolfgang**
**97076 Würzburg (DE)**

(74) Vertreter: **Wegner, Hans**
**Bardehle Pagenberg Partnerschaft mbB**
**Patentanwälte, Rechtsanwälte**
**Prinzregentenplatz 7**
**81675 München (DE)**

(56) Entgegenhaltungen:
JP-A- 10 144 991          JP-A- 2001 024 275
US-A- 5 982 804          US-A1- 2003 007 719
US-A1- 2007 002 914          US-B1- 6 301 283

• **FIEBIG C ET AL: "High-Power DBR-Tapered Laser at 980 nm for Single-Path Second Harmonic Generation" IEEE JOURNAL OF SELECTED TOPICS IN QUANTUM ELECTRONICS, IEEE SERVICE CENTER, PISCATAWAY, NJ, US, Bd. 15, Nr. 3, 1. Mai 2009 (2009-05-01), Seiten 978-983, XP011251660 ISSN: 1077-260X**
• **WENZEL H ET AL: "Fundamental-Lateral Mode Stabilized High-Power Ridge-Waveguide Lasers With a Low Beam Divergence" IEEE PHOTONICS TECHNOLOGY LETTERS, IEEE SERVICE CENTER, PISCATAWAY, NJ, US, Bd. 19, Nr. 3, 1. Februar 2008 (2008-02-01), Seiten 214-216, XP011203011 ISSN: 1041-1135**
• **RYVKIN B ET AL: "Asymmetric, nonbroadened large optical cavity waveguide structures for high-power long-wavelength semiconductor lasers" JOURNAL OF APPLIED PHYSICS, AMERICAN INSTITUTE OF PHYSICS. NEW YORK, US, Bd. 97, Nr. 12, 16. Juni 2005 (2005-06-16) , Seiten 123103-1-123103-6, XP012070328 ISSN: 0021-8979**
• **VIHERIALA J ET AL: "Surface-grating-based distributed feedback lasers fabricated using nanoimprint lithography" SEMICONDUCTOR CONFERENCE, 2008. CAS 2008. INTERNATIONAL, IEEE, PISCATAWAY, NJ, USA, 13. Oktober 2008 (2008-10-13), Seiten 95-98, XP031372851 ISBN: 978-1-4244-2004-9**
• **Wolfgang Zeller et al.: "High-Power pulsed 976-nm DFB laser diodes" In: "Proceedings of the SPIE" 28. April 2010 (2010-04-28), , XP002587963 Bd. 7682, , Seiten 76820T-1-76820T-9 * Zusammenfassung; Abbildung 2 * Kapitel 2: "DEVICE DESIGN" ***

EP 2 427 937 B1

**Beschreibung**

**1. Technisches Gebiet**

Die vorliegende Erfindung betrifft eine DFB Laserdiode mit lateraler Kopplung für große Ausgangsleistungen.

**2. Stand der Technik**

Laserdioden spielen bereits heute in vielen Wirtschaftsbereichen als kohärente Lichtquellen eine wichtige Rolle. Stellvertretend seien hier nur zwei Anwcndungsfelder herausgegriffen: der Einsatz zur Datenübertragung im Telekommunikationsbereich und als Analysewerkzeug in dem Gebiet der Sensorik. In diesen wie in den meisten anderen Anwendungsgebieten ist es von entscheidender Bedeutung, dass die Laserdiode im Wesentlichen nur Strahlung einer einzigen Eigenschwingung des Laserresonators emittiert und dass die Bandbreite dieser einzigen Eigenschwingung klein ist.

Normalerweise emittieren Halbleiterlaser aufgrund ihres breiten Verstärkungsspektrums Licht in mehreren Eigenschwingungen. Um sicher zu stellen, dass die emittierte Laserstrahlung im Wesentlichen nur Licht einer einzigen Eigenschwingung aufweist, wurde bereits vor längerer Zeit das Konzept der verteilten Rückkopplung (Distributed Feedback oder abgekürzt DFB) des Laserlichts zwischen den beiden Spiegeln des Laserresonators entwickelt. Zur Herstellung von solchen DFB Laserdioden wird der Epitaxieprozess, mit dem die Schichtfolge der Laserdiode auf ein Halbleitersubstrat aufgewachsen wird, unterbrochen und in die aktive Schicht selber oder eine der darüber oder darunter liegenden Schichten wird eine periodische Änderung des Brechungsindex und/oder der Absorption für die emittierte Strahlung eingeführt. Dadurch wird die Schwellenverstärkung einer Eigenschwingung des Resonators reduziert und/oder die Schwellenverstärkung aller anderen Eigenschwingungen innerhalb des Verstärkungsspektrums erhöht, so dass der Halbleiterlaser nur Licht einer Eigenschwingung (und damit einer Wellenlänge) emittiert. In einem zweiten Epitaxieschritt werden dann die noch fehlenden Schichten abgeschieden. Diese Unterbrechung des Schichtwachstums ist allerdings problematisch: zum einen ist dieser Herstellungsprozess aufwändig und zum anderen kann durch den Strukturierungsprozess und den zweiten Epitaxieprozess die Qualität der die Laserdiode bildenden Schichten durch das Einführen von Kristalldefekten beeinträchtigt werden. Dies kann sich negativ auf die Ausbeute und insbesondere auch auf die Lebensdauer der DFB Laserdioden auswirken.

Das vor einigen Jahren entwickelte Konzept der lateralen Kopplung von DFB Laserdioden, das in der Patentschrift EP 0 984 535 B1 beschrieben ist, überwindet die erwähnten Nachteile der oben beschriebenen herkömmlichen DFB Laser. Im Folgenden bezeichnet die laterale Richtung, die Richtung parallel zu der Schichtenfolge und senkrecht zu der Ausbreitung des Lichts. Die Richtung senkrecht zu der Schichtenfolge und senkrecht zu der Lichtausbreitungsrichtung wird transversale Richtung genannt. Die longitudinale Richtung bezeichnet nachfolgend die Ausbreitungsrichtung der Laserstrahlung in dem Laserresonator.

DFB Laserdioden mit lateraler Kopplung werden in einem einzigen Epitaxieprozess hergestellt. Ein wichtiger Vorteil des Konzepts der lateralen DFB Kopplung liegt darin, dass nach der Herstellung der Laserstruktur deren Emissionsspektrum gemessen werden kann und anhand der gewonnenen Messergebnisse die gewünschte Emissionswcllcnlängc über die Periode der Oberflächenstruktur exakt eingestellt werden kann.

Durch das Herstellen von DFB Laserdioden mit lateraler Kopplung in einem einzigen Epitaxieprozess kann bei diesem Lasertyp die Kristallqualität der die Laserdiode bildenden Schichtfolge nicht durch das Unterbrechen des Schichtwachstums, einen Strukturierungsprozess und den zweiten Epitaxieprozess beeinträchtigt werden. In Verbindung mit der präzise einstellbaren Emissionswellenlänge führt dies zu einer großen Ausbeute in dem Produktionsprozess.

DFB Laserdioden mit lateraler Kopplung finden vorzugsweise als monomodale Lichtquellen für kleine oder mittlere Ausgangsleistungen Verwendung. Aufgrund ihres verteilten Rückkopplungsmechanismus weisen DFB Laserdioden im Allgemeinen eher geringe Ausgangsleistungen auf. Einige Anwendungen erfordern jedoch das Bereitstellen großer Lichtleistungen, die nach dem Stand der Technik gefertigte DFB Laserdioden mit lateraler Kopplung nicht liefern können.

Bei Laserdioden, die für große Ausgangsleistungen ausgelegt sind, tritt die größte optische Leistungsdichte in der Regel an dem oder den Spiegeln des Laserresonators auf. Degradationsprozesse von Laserspiegeln durch das Bilden einer Oxidschicht sind sei längerem bekannt; diese Prozesse werden durch die Anwesenheit einer sehr großen Photonendichte verstärkt. Diese Degradationsvorgänge führen schließlich zu einem plötzlichen Zerstören des Laserspiegels durch lokales Aufschmelzen des Halbleitermaterials. Dieser Vorgang wird als catastrophic optical damage oder COD bezeichnet. Damit ist ein ganz wesentlicher Faktor, der die aus dem Laserresonator auskoppelbare Lichtleistung begrenzt, die optische Leistungsdichte, die an einem Laserspiegel auftreten darf, die nicht zu einem beschleunigten Alterungsprozess der Laserdiode durch Degradation ihrer Laserspiegel führt.

Eine Möglichkeit zur Verringerung der Geschwindigkeit dieser Degradationsprozesse ist das Beschichten der Laserspiegel mit einem dielektrischen Material. Dieser Vergütungsprozess ist von M. Fukuda in "Semiconductor Lasers and LEDs" auf den Seiten 134 - 136 beschrieben.

Das US Patent mit der Nr. 4 328 469 offenbart eine Heterostruktur-Injektionslaserdiode deren aktive Schicht in eine Wellenleiterstruktur eingebettet ist. Die US 2003/0007766 A1 beschreibt eine Wellenleiterkomponente deren Wellenleiter sich in Richtung einer Frontseite verjüngt. Die US 2004/0017836 A1 offenbart ein einmodiges optisches Gerät mit einer Absorptions- und Isolationsschicht, um höhere transversale Moden zu unterdrücken. Die US 2008/0144691 A1 beschreibt optisches Halbleitergerät, bei dem ein Beugungsgitter auf beiden Seiten eines Wellenleiters angeordnet ist. Die US 2002/0141582 A1 offenbart einen Leuchtfleck-Konverter, der in einem optischen Gerät integriert ist.

Der vorliegenden Erfindung liegt daher das Problem zu Grunde, Maßnahmen anzugeben, die es ermöglichen, große Lichtleistungen aus DFB Laserdioden mit lateraler Kopplung auszukoppeln, ohne dass es zu den oben beschriebenen Degradationsprozessen kommt und ohne dass andere Kenngrößen der Laserdioden signifikant verschlechtert werden.

Die US Patentschrift mit der Nr. 5 982 804 offenbart ein Verfahren zum Herstellen eines lateral gekoppelten DFB Halbleiterlasers, der eine obere und eine untere Wellenleiterschicht aufweist. Ferner hat der Halbleiterlaser eine obere und eine untere Mantelschicht. Auf die Kontaktschicht des Wellenleiterstegs wird vor dem Aufbringen der Photolackschicht eine Schutzschicht aufgebracht. Damit wird verhindert, dass beim Ätzen des Gitters in die obere Mantelschicht eine Gitterstruktur auf dem Wellenleitersteg geätzt wird, was einen schlechten elektrischen Kontakt zur Folge haben würde.

Die JP 2001 024275 beschreibt einen Herstellungsprozess für einen lateral gekoppelten DFB Quantenfilm-Laser. Der Quantenfilm-Laser weist eine asymmetrische Wellenleiterstruktur auf, wobei die untere n-dotierte Wellenleiterschicht eine Dicke von 100 nm hat und der obere p-dotierte Wellenleiter mit einer Schichtdicke von 10 nm angegeben ist. Die lateral angeordnete Gitterstruktur ist ein Beugungsgitter aus einem Isolatormaterial. Eine Laserfacette ist bis auf 1% Reflektivität entspiegelt und die zweite Laserfacette weist eine Verspiegelungsschicht mit einer Reflektivität von 90% auf.

Der Artikel "High-Power DBR-Tapered Laser at 980 nm for Single-Path Second Harmonie Generation" von C. Fiebig et al., IEEE J. of Selected Topics in Quantum Electronics, Vol. 15, No. 3, May/June 2009, S. 978-983 präsentiert experimentelle Ergebnisse von Kanten-emittierenden DBR getaperten Diodenlasern, die bei 980 nm emittieren. Die untersuchten Laser zeigen eine Ausgangsleistung von bis zu 12W mit einem Konversionswirkungsgrad von ungefähr 45%. Die Laser zeigen eine kleine vertikale Divergenz < 15° für die volle Breite bei der halben Intensität (FWHM), eine nahezu beugungsbegrenzte Strahlqualität und eine kleine spektrale Linienbreite (FWHM) mit kleiner 12 pm.

Die US 2007/0002914 A1 offenbart eine Halbleiter-Laserdiode mit einer n-dotierten unteren Mantelschicht, einer n-dotierten unteren optischen Wellenleiterschicht, einer aktiven Schicht, einer p-dotierten oberen optischen Wellenleiterschicht und einer p-dotierten oberen Mantelschicht, die auf einem Substrat gebildet werden. Die Dicke der n-dotierten unteren optischen Wellenleiterschicht ist größer die der p-dotierten oberen Wellenleiterschicht.

Der Artikel "Fundamental-Lateral Mode Stabilized High-Power-Ridge Waveguide Lasers With a Low Beam Divergence" von H. Wenzel et al., IEEE Phot. Techn. Lett., Vol. 20, No. 3, Feb. 1, 2008, S. 214-216 vergleicht Streifenwellensteg-Laser mit Grabenbreiten von 5 und 20 $\mu$m. Die Laser emittieren bei etwa 1064 nm und die Streifenbreite beträgt 5 $\mu$m. Die Ausgangsleistung ist größer als 2 W. Die volle Breite bei der halben Intensität des vertikalen Fernfeldprofils beträgt nur 15° infolge eines supergroßen optischen Resonators.

Der Artikel "Asymmetric, nonbroadened large optical cavity waveguide structures for high-power long-wavelength semiconductor lasers" von B.S. Ryvkin und E.A. Avrutin in J. of Appl. Phys. 97, (2005) S. 123103-1 bis 123103-6 stellt ein einfaches semianalytisches Modell zum Berechnen der durch freie Ladungsträger verursachten Verluste vor, das nachweist, dass diese Verluste bei großen Strömen ein wichtiger Faktor werden können. Es wird gezeigt, dass nicht verbreitete asymmetrische Wellenleiterstrukturen diese Verluste wesentlich reduzieren können mit wenig oder keiner Verschlechterung de Schwellen-, der Nahfeld- und Fernfeldeigenschaften. Das US Patent mit der Nr. 6 301 283 B1 offenbart einen DFB Laser, der aufweist: ein Halbleitersubstrat, eine aktive Schicht, die auf dem Substrat gebildet wird, einen Streifenwellenleiter, der auf der aktiven Schicht gebildet ist, eine periodische Struktur, die sich entlang des Streifenwellenleiters erstreckt, und wobei der Streifenwellenleiter zumindest zwei verschiedene Breiten aufweist.

Die US 2003/0007719 A1 beschreibt feine integrierte photonische Schaltung, die einen ersten Wellenleiter mit einer sich darin ausbreitenden ersten Mode und einen zweiten Wellenleiter mit einer sich darin ausbreitenden zweiten Mode umfasst. Die ersten und die zweiten Moden haben unterschiedliche effektive Brechungsindices. Ein Taper, der auf dem zweiten Wellenleiter gebildet ist erleichtert die Übertragung des Lichts zwischen den Wellenleitern.

Der Artikel "Surface-grating-based distributed feedback lasers fabricated using nanoimprint lithography" von. J. Viheriiälä et at., Semiconductor Conf. 2008, CAS 2008, Intern., IEEE, Piscataway, NJ, USA berichtet über das Herstellen von DFB Lasern einem Gitter 3. Ordnung, das durch laterale Riffelung des Stegwellenleiters erhalten wird. Die Laser weisen eine Nebenmodenunterdrückung von mehr als 50 dB auf.

### 3. Zusammenfassung der Erfindung

Gemäß der vorliegenden Erfindung wird dieses Problem durch eine Vorrichtung nach Anspruch 1 gelöst. Weitere Ausführungsformen der Erfindung sind in den abhängigen Ansprüchen 2 bis 17 definiert. Die DFB Laserdiode mit lateraler Kopplung gemäß der vorliegende Erfindung weist die folgenden Merkmale auf:

a. zumindest ein Halbleitersubstrat;

b. zumindest eine auf dem Halbleitersubstrat angeordnete aktive Schicht;

c. zumindest einen oberhalb der aktiven Schicht angeordneten Wellenleitersteg; wobei

d. zumindest eine neben dem Wellenleitersteg oberhalb der aktiven Schicht angeordnete periodische Oberflächenstruktur, wobei die periodische Oberflächenstruktur nach einem Ätzprozess auf die verbleibende obere Mantelschicht aufgebracht wird; und

e. zumindest eine unterhalb und oberhalb der aktiven Schicht angeordnete Wellenleiterschicht, wobei die untere Wellenleiterschicht eine Dicke im Bereich von 1 $\mu$m bis 5 $\mu$m, bevorzugt 1,5 $\mu$m bis 3 $\mu$m und besonders bevorzugt von 2 ,0 $\mu$m bis 2,5 $\mu$m aufweist und die obere Wellenleiterschicht eine Dicke im Bereich von 15 nm bis 100 nm und bevorzugt von 20 nm bis 50 nm aufweist.

Durch die dicke Wellenleiterschicht kann sich die räumliche Verteilung der optischen Intensität in dieser Schicht und damit senkrecht zu der Schichtfolge über eine größere Distanz ausbreiten. Diese Aufweitung der Laserstrahlung in transversaler Richtung resultiert bei gleicher in der Lasermode geführter optischer Leistung in einer Reduzierung des Maximums der optischen Intensität. Damit wird bei gleicher optischer Leistung der Lasermode die maximale optische Leistungsdichte auf dem Laserspiegel und damit auch dessen Belastung geringer. Bei vorgegebener Maximalbelastbarkeit des Laserspiegels kann somit die aus dem Laserresonator auskoppelbare Lichtleistung gesteigert werden. Zudem führt die breitere Verteilung der Strahlung der Lasermode in Richtung der Schichtfolge des Laserresonators zu einem geringeren transversalen Divergenzwinkel des Laserlichts nach seinem Austritt aus dem Laserresonator. Durch diese geringere Strahldivergenz in transversaler Richtung, die sich dem Divergenzwinkel in lateraler Richtung annähert, ergibt sich eine einfachere und gleichzeitig effizientere Kopplung der Laserstrahlung in optische Elemente.

Die oberhalb der aktiven Schicht angeordnete periodische Oberflächenstruktur kann in longitudinaler Richtung über die gesamte Länge der aktiven Schicht angeordnet sein. Es ist jedoch auch möglich, dass sich die periodische Oberflächenstruktur nur teilweise über den Bereich der aktiven Schicht erstreckt. Ferner ist es denkbar, dass die periodische Oberflächenstruktur und die aktive Schicht in longitudinaler Richtung vollständig getrennt von einander angeordnet sind.

In der erfindungsgemäßen DFB Laserdiode mit lateraler Kopplung weist die Wellenleiterschicht eine Dicke im Bereich von 1,0 $\mu$m bis 5,0 $\mu$m, bevorzugt 1,5 $\mu$m bis 3,0 $\mu$m und besonders bevorzugt von 2,0 $\mu$m bis 2,5 $\mu$m auf. Die für die Wellenleiterschicht angegebenen Schichtdicken haben sich als optimal für DFB Laserdioden mit lateraler Kopplung herausgestellt, die Licht in einem Wellenlängenbereich von 900 nm bis 1000 nm emittieren. Bei konstantem Brechungsindexvon aktiver Schicht und Wellenleiterschicht skaliert die Dicke der Wellenleiterschicht linear mit der Wellenlänge des Laserlichts.

Bei DFB Laserdioden mit lateraler Kopplung führt eine dicke Wellenleiterschicht oberhalb der aktiven Schicht dazu, dass die emittierte Laserstrahlung durch Verringerung der räumlichen Überlappung mit der periodischen Oberflächenstruktur von dieser weitgehend entkoppelt wird. Die Wirkung der verteilten Rückkopplung und damit die Unterdrückung von weiteren Eigenschwingungen des Laserresonators innerhalb der Verstärkungsbandbreite kann dadurch verringert werden. Durch die Kombination einer dünnen Wellenleiterschicht oberhalb und einer dicken Wellenleiterschicht unterhalb der aktiven Schicht kann eine Verringerung des Kopplungsfaktors der periodischen Oberflächenstruktur weitgehend verhindert werden. Gleichzeitig vergrößert sich durch diese Schichtkombination die Ausdehnung der optischen Intensität in transversaler Richtung im Vergleich zum herkömmlichen Schichtdesign nach dem Stand der Technik. Dies bewirkt einen kleineren Fernfeldwinkel in transversaler Richtung. Damit ergibt sich ein größerer Wirkungsgrad bei der Einkopplung der Lascrstrahlung in rotationssymmctrischc Optiken, was bei gleicher von der Laserdiode emittierter Lichtleistung zu größerer verfügbarer oder nutzbarer optischer Leistung führt.

In einer besonders bevorzugten Ausführungsform weist die unterhalb der aktiven Schicht angeordnete Wellenleiterschicht eine Schichtdicke $\geq 1$ $\mu$m und die oberhalb der aktiven Schicht angeordnete Wellenleiterschicht eine Dicke $\leq 1$ $\mu$m auf. Diese Angaben sind wiederum für Laserdioden optimal, die Licht in dem Wellenlängenbereich von 900 nm bis 1000 nm emittieren. Bei Beibehaltung konstanter Brechungsindicesfür die der aktive Schicht und die Wellenleiterschichten variiert die Schichtdicke der dicken Wellenleiterschicht (Schichtdicke $\geq 1$ $\mu$m) linear mit der Wellenlänge der Laserstrahlung.

In einer ganz besonders bevorzugten Ausführungsform weist die untere Wellenleiterschicht eine Dicke im Bereich von 1,0 $\mu$m bis 5,0 $\mu$m, bevorzugt 1,5 $\mu$m bis 3,0 $\mu$m und besonders bevorzugt von 2,0 $\mu$m bis 2,5 $\mu$m auf und die obere Wellenleiterschicht weist eine Dicke im Bereich von 10 nm bis 500 nm, bevorzugt 15 nm bis 100 nm und besonders bevorzugt von 20 nm bis 50 nm auf.

In einer weiteren bevorzugten Ausführungsform liegt die Brechungsindexdifferenz zwischen der aktiven Schicht und der Wellenleiterschicht in einem Bereich von 0,04 bis 0,40, bevorzugt von 0,06 bis 0,30 und besonders bevorzugt von 0,08 bis 0,25. Diese Brechungsindexdifferenz ist wiederum optimiert für den Wellenlängenbereich des Laserlichts von 900 nm bis 1000 nm. Bei größeren Wellenlängen kann eine Vergrößerung geometrischer Parameter wie z.B. von Schichtdicken, Wellenleiterstegbreiten und Gitterperioden notwendig sein.

Gemäß einer Ausführungsform der vorliegende Erfindung wird der Querschnitt des Wellenleiterstegs, vorzugsweise dessen Breite, in Richtung zumindest eines Laserspiegels kleiner.

Durch die Verjüngung oder Taperung des Wellenleiterstegs in Richtung eines Laserspiegels wird die Intensitätsverteilung der Lasermode nach unten in Richtung der unteren Wellenleiterschicht verschoben. Insbesondere bei einer dicken unteren Wellenleiterschicht führt dies gleichzeitig zu einer Verbreiterung der optischen Intensitätsverteilung an dem Laserspiegel innerhalb der unteren Wellenleiterschicht. Damit gekoppelt ist eine Reduzierung der maximalen Intensitätsdichte am Laserspiegel, was wiederum zur Steigerung der über den Laserspiegel aus dem Resonator auskoppelbaren Lichtleistung benutzt werden kann. Überdies führt die durch die Taperung hervorgerufene Verbreiterung der transversalen Intensitätsverteilung zu einer Verkleinerung des Divergenzwinkels der aus dem Laserresontor abgestrahlten Lichtleistung in transversaler Richtung. Dadurch kann erreicht werden, dass sich der transversale und der laterale Divergenzwinkel nahezu angleichen. Damit wird durch die Taperung des Wellenleiterstegs die Voraussetzung geschaffen, um Laserstrahlung leicht und gleichzeitig mit sehr großem Wirkungsgrad in optische Elemente einzukoppeln.

Neben der Verringerung der Breite des Wellenleiterstegs kann die optische Intensitätsverteilung gleichfalls durch eine Verringerung der Höhe des Wellenleiterstegs in Richtung der unteren Wellenleiterschicht verschoben werden. Ferner kann eine Verjüngung des Wellenleiterstegs und eine Verringerung seiner Höhe in Richtung zumindest eines Laserspiegels kombiniert werden.

Eine ganz besonders bevorzugte Ausführungsform weist zumindest eine unterhalb und oberhalb der aktiven Schicht angeordnete Wellenleiterschicht auf, wobei die Schichtdicken der beiden Wellenleiterschichten unterschiedlich sind, und der Querschnitt des Wellenleiterstegs, vorzugsweise dessen Breite, wird in Richtung zumindest eines Laserspiegels kleiner.

In einer bevorzugten Ausführungsform wird die Breite des Wellenleiterstegs in Richtung zumindest eines Laserspiegels linear kleiner. In einer anderen bevorzugten Ausführungsform wird die Breite des Wellenleiterstegs in Richtung zumindest eines Laserspiegels exponentiell kleiner.

In einer weiteren bevorzugten Ausführungsform weist der Wellenleitersteg eine Breite im Bereich von 0,5 $\mu$m bis 10 $\mu$m, bevorzugt von 1,0 $\mu$m bis 7,0 $\mu$m und besonders bevorzugt von 2,0 $\mu$m bis 4,0 $\mu$m auf. In einer anderen bevorzugten Ausführungsform weist der Wellenleitersteg an zumindest einem Laserspiegel eine Breite im Bereich von 0 nm bis 1000 nm, bevorzugt von 100 nm bis 700 nm und besonders bevorzugt von 200 nm bis 500 nm auf.

In einer besonders bevorzugten Ausführungsform erfolgt die Verkleinerung der Breite des Wellenleiterstegs in Richtung zumindest eines Laserspiegels über eine Länge im Bereich von 50 $\mu$m bis 1000 $\mu$m, bevorzugt von 100 $\mu$m bis 600 $\mu$m und besonders bevorzugt von 200 $\mu$m bis 400 $\mu$m.

In einer besonders bevorzugten Ausführungsform wird die Breite des Wellenleiterstegs in Richtung beider Laserspiegel kleiner. Gemäß einer Ausführungsform der vorliegenden Erfindung ist der Brechungsindex der in dem Wellenleitersteg angeordneten Schicht größer als der Brechungsindex des Wellenleiterstegs.

Eine in dem Wellenleitersteg eingebettete Schicht mit großem Brechungsindex führt dazu, dass in dem Bereich des Wellenleiterstegs die optische Intensitätsverteilung in Richtung dieser zusätzlichen Schicht deformiert wird. Die modifizierte transversale Intensitätsverteilung ändert die Stärke der Kopplung der Lasermode an die auf der oberen Wellenleiterschicht angeordnete periodische Oberflächenstruktur. Dadurch wird es möglich, eine durch eine verbreiterte obere Wellenleiterschicht verursachte verringerte Kopplungskonstante zwischen Lasermode und periodischer Oberflächenstruktur zumindest teilweise zu kompensieren. Die in den Wellenleitersteg eingebettete Schicht mit großem Brechungsindex eröffnet damit einen weiteren Freiheitsgrad, um die maximale Intensitätsdichte auf dem Laserspiegel zu reduzieren, ohne dadurch andere wichtige Laserkenngrößen signifikant zu verschlechtern.

Eine besonders bevorzugte Ausführungsform weist die in dem Wellenleitersteg angeordnete Schicht auf, deren Brechungsindex größer als der Brechungsindex des Wellenleiterstegs ist und weist zumindest eine unterhalb und oberhalb der aktiven Schicht angeordnete Wellenleiterschicht auf, wobei die Schichtdicken der beiden Wellenleiterschichten unterschiedlich sind.

Eine weitere besonders bevorzugte Ausführungsform weist die in dem Wellenleitersteg angeordnete Schicht auf, deren Brechungsindex größer als der Brechungsindex des Wellenleiterstegs ist und der Querschnitt des Wellenleiterstegs, vorzugsweise dessen Breite, wird in Richtung zumindest eines Laserspiegels kleiner.

Eine ganz besonders bevorzugte Ausführungsform weist die in dem Wellenleitersteg angeordnete Schicht auf, deren Brechungsindex größer als der Brechungsindex des Wellenleiterstegs ist, weist zumindest eine unterhalb und oberhalb der aktiven Schicht angeordnete Wcllcnlcitcrschicht auf, wobei die Schichtdicken der beiden Wellenleiterschichten unterschiedlich sind und der Querschnitt des Wellenleiters, vorzugsweise dessen Breite, wird in Richtung zumindest eines Laserspiegels kleiner.

In einer besonders bevorzugten Ausführungsform ist die Schicht hohen Brechungsindexes oberhalb der periodischen Gitterstruktur angeordnet.

In einer bevorzugten Ausführungsform liegt die Brechungsindexdifferenz zwischen der Schicht hohen Brechungsindexes und des Wellenleiterstegs in einem Bereich von 0,10 bis 0,40, bevorzugt von 0,15 bis 0,35 und besonders bevorzugt von 0,20 bis 0,30. Diese Brechungsindexdifferenz ist sehr günstig für DFB Laserdioden mit lateraler Kopplung deren Emissionswellenlängen in den Bereich von 900 nm bis 1000 nm fallen. Für andere Materialsysteme mit deren Hilfe Halbleiterlaser hergestellt werden, die Licht in anderen Wellenlängenbereichen emittieren kann diese Brechungsindexdifferenz andere Werte annehmen.

## 4. Beschreibung der Zeichnungen

In der folgenden detaillierten Beschreibung werden derzeit bevorzugte Ausführungsbeispiele der Erfindung unter Bezugnahme auf die Zeichnungen 10 bis 20 beschrieben, wobei

Fig. 1     eine schematische Darstellung der wichtigsten Schichten einer DFB Laserdiode darstellt, die eine periodische Oberflächenstruktur zur lateralen Kopplung an die im Laserresonator erzeugte Strahlung aufweist;

Fig. 2     eine simulierte zweidimensionale optische Intensitätsverteilung in normierter Darstellung in der Ebene eines Lascrspicgcls für eine DFB Laserdiode mit lateraler Kopplung mit einer Wellenleiterstruktur nach dem Stand der Technik zeigt;

Fig. 3     einen vertikalen Schnitt der optischen Intensitätsverteilung der Fig. 2 durch das Maximum der Photonendichteverteilung repräsentiert;

Fig. 4     laterale und transversale Fernfeldverteilungen der optischen Intensität der DFB Laserdiode mit lateraler Kopplung der Figuren 1 - 3 zeigt;

Fig. 5     eine schematische Darstellung der wichtigsten Schichten einer DFB Laserstruktur mit lateraler Kopplung zeigt, wobei die untere und die obere Wellenleiterschicht jeweils eine große Dicke aufweisen und somit in Form einer LOC (large optical cavity) ausgeführt sind;

Fig. 6     die simulierte zweidimensionale optische Intensitätsverteilung in normierter Darstellung in der Ebene eines Laserspiegels für eine DFB Laserdiode mit lateraler Kopplung mit der Wellenleiterstruktur der Fig. 5 zeigt;

Fig. 7     einen vertikalen Schnitt der optischen Intensitätsverteilung der Fig. 6 durch das Maximum der Photonendichteverteilung wiedergibt;

Fig. 8     simulierte transversale Fernfeldverteilungen der optischen Intensität einer DFB Laserdiode mit lateraler Kopplung mit einer Wellenleiterstruktur nach dem Stand der Technik und mit symmetrischen, dicken Wellenleiterschichten unterhalb und oberhalb der aktiven Schicht (symmetrische LOC) zeigt;

Fig. 9     eine schematische Darstellung der wichtigsten Schichten einer DFB Laserstruktur mit lateraler Kopplung zeigt, wobei die untere Wellenlcitcrschicht eine viel größere Dicke als die obere Wcllcnlcitcrschicht aufweist, die somit eine asymmetrische LOC bilden;

Fig. 10    eine simulierte zweidimensionale optische Intensitätsverteilung in normierter Darstellung in der Ebene eines Laserspiegels für eine DFB Laserdiode mit lateraler Kopplung mit der Wellenleiterstruktur der Fig. 9 zeigt;

Fig. 11    einen vertikalen Schnitt der optischen Intensitätsverteilung der Fig. 10 durch das Maximum der Photonendichteverteilung repräsentiert;

Fig. 12    simulierte transversale Fernfeldverteilungen der optischen Intensität einer DFB Laserdiode mit lateraler Kopplung mit einer Wellenleiterstruktur nach dem Stand der Technik (Fig. 1), mit einer symmetrischen LOC (Fig. 5) und mit einer asymmetrischen LOC (Fig. 9) zeigt;

Fig. 13    die schematische Darstellung der Fig. 9 wiedergibt, in die zusätzlich in den Wellenleitersteg oberhalb der periodischen Gitterstruktur eine Schicht mit großem Brechungsindex eingefügt wurde;

Fig. 14    eine simulierte zweidimensionale optische Intensitätsverteilung in normierter Darstellung in der Ebene eines Laserspiegels für die DFB Laserdiode mit lateraler Kopplung der Fig. 13 wiedergibt;

Fig. 15    einen vertikalen Schnitt der simulierten optischen Intensitätsverteilung der Fig. 14 durch das Maximum der Photonendichteverteilung repräsentiert;

Fig. 16    die schematische Darstellung eines Teils der Fig. 9 zeigt, wobei zusätzlich der Wellenleitersteg in Richtung eines Laserspiegels eine lineare Tapcrung aufweist;

Fig. 17    die schematische Darstellung eines Teils der Fig. 9 wiedergibt, wobei zusätzlich der Wellenleitersteg in Richtung eines Laserspiegels eine exponentielle Taperung aufweist;

Fig. 18    die simulierte zweidimensionale optische Intensitätsverteilung in normierter Darstellung an dem Laserspiegel für eine DFB Laserdiode mit lateraler Kopplung mit der Wellenleiterstruktur der Fig. 9 sowie der Taperung der Fig. 17 zeigt;

Fig. 19    simulierte transversale Fernfeldverteilungen der optischen Intensität einer DFB Laserdiode mit lateraler Kopplung mit einer Wellenleiterstruktur gemäß des Standes der Technik (Fig. 1), mit einer symmetrischen LOC (Fig. 5), mit einer asymmetrischen LOC (Fig. 9) und mit einer Taperung des Wellenleiterstegs (Fig. 17) zeigt;

Fig. 20    die simulierte zweidimensionale optische Intensitätsverteilung der Fig. 18 zeigt bei der zusätzlich nach Fig. 13 eine Schicht großen Brechungsindexes in den Wellenleitersteg eingefügt wurde.

## 5. Detaillierte Beschreibung bevorzugter Ausführungsbeispiele

Im Folgenden werden bevorzugte Ausführungsformen der erfindungsgemäßen Vorrichtungen genauer erläutert.

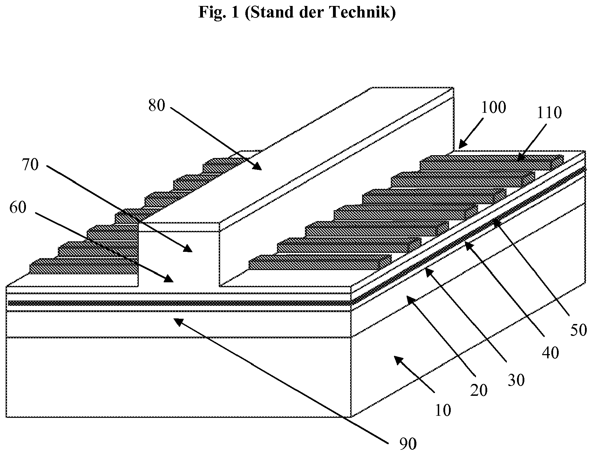

In der Fig. 1 sind schematisch die wichtigsten Schichten dargestellt, die eine DFB Laserdiode mit lateraler Kopplung repräsentieren. Die verschiedenen Schichten werden in einem Epitaxieprozess auf einem Halbleitersubstrat 10 abgeschieden. Das Matcrialsystcm des Halblcitcrsubstrats 10 wird durch die zu realisierende Wellenlänge der Laserdiode bestimmt. Die nachfolgend detailliert ausgeführten erfindungsgemäßen Prinzipien können auf alle bekannten Materialsysteme angewandt werden, um Laserdioden herzustellen, die Licht vom blauen (beispielsweise auf Galliumnitrid-Substraten) bis tief in den infraroten Wellenlängenbereich (beispielsweise auf Galliumantimonid-Substraten) emittieren. Neben Substraten auf der Basis von III/V Verbindungshalbleitern können die offenbarten Prinzipien auch auf DFB Laserdioden mit lateraler Kopplung angewendet werden, die auf II/VI Halbleitersubstraten oder anderen geeigneten Substraten aufgebaut sind. Die nachfolgende Beschreibung erläutert die erfindungsgemäßen Prinzipien an DFB Laserdioden mit lateraler Kopplung des Materialsystems GaAs/Al$_x$Ga$_{(1-x)}$As(Galliumarsenid/Aluminiumgalliumarsenid).

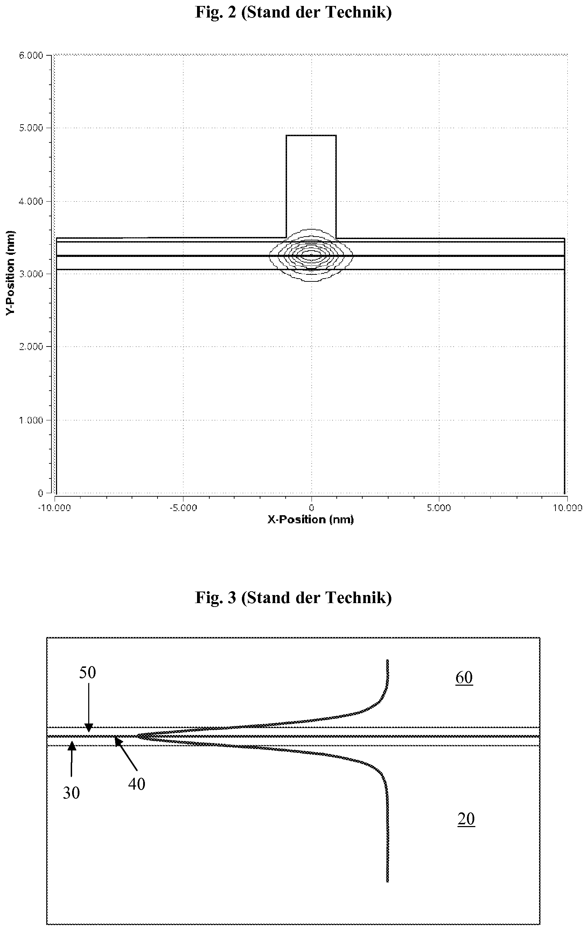

Auf das Substrat 10 wird als erstes eine dicke (d $\approx$ 1 $\mu$m) untere Mantelschicht 20 (siehe Fig. 3) abgeschieden. Diese Schicht ist in der Regel hoch dotiert, um eine gute elektrische Leitfähigkeit zu gewährleisten und weist einen großen Aluminiumanteil (x $\approx$ 0,3) zur Ausbildung eines geringen Brechungsindexes auf. Es ist auch möglich auf eine untere Mantelschicht 20 aus Einfachheitsgründen zu verzichten. Das Halbleitersubstrat 10 übernimmt in diesem Fall die Funktion der unteren Mantelschicht 20.

Auf die untere Mantelschicht 20 folgt die untere Wellenleiterschicht 30, deren Dicke für DFB Laserdioden mit lateraler Kopplung nach dem Stand der Technik im Bereich von 200 nm liegt. Der Aluminiumanteil der unteren Wellenleiterschicht 30 liegt zwischen dem der unteren Mantelschicht 20 und dem der aktiven Schicht 40. Damit weist auch der Brechungsindex einen Zahlenwert auf, der in dem Bereich zwischen dem niedrigen Wert der unteren Mantelschicht 20 und dem großen Zahlenwert der aktiven Schicht 40 liegt.

Die aktive Schicht 40 ist die Schicht in der zumindest in Teilen Besetzungsinversion möglich ist. Dieser Zustand führt zu einer sehr großen spontanen Photonenemissionsrate in dem Bereich der Verstärkungsbandbreite des Halblcitcrmatcrials in dem Besetzungsinversion herrscht. Die durch spontane Emission erzeugten Photonen, die im Wesentlichen in longitudinaler Richtung emittiert werden, bauen in Folge der Reflexion an den Laserspiegeln durch stimulierte Emission die kohärente optische Intensitätsverteilung mehrerer Eigenschwingungen des Laserresonators, die im Maximum der Verstärkungsbandbreite liegen, auf. Bei DFB Laserdioden mit lateraler Kopplung führt die Modulation der Nettoverstärkung, d.h. der Materialverstärkung vermindert um die interne Absorption, durch die frequenzselektive Absorption von Photonen an der periodischen Oberflächenstruktur zur Auswahl einer einzigen longitudinalen Eigenschwingung des Laserresonators.

Die aktive Schicht kann als eine dünne Bulk-Schicht (d $\approx$ 0,2 $\mu$m) mit keinem oder einem sehr geringen Aluminiumanteil (x $\leq$ 0,05) ausgebildet sein. In modernen DFB Laserdioden mit lateraler Kopplung weist die aktive Schicht eine sehr feine zusätzliche Strukturierung in Form von einem oder mehreren Quantenfilmen (quantum wells) oder einem oder einer Vielzahl von Quantenpunkten (quantum dots) auf. Für den mittleren Infrarotbereich ($\lambda \geq 4\ \mu m$) können Indiumphosphid (InP) Quantenkaskadenlaser eingesetzt werden, deren aktive Schicht aus vielen dünnen InAlAs/InGaAs Perioden bestehen. Des Weiteren können Quantenkaskadenlaser auf Galliumarsenid- oder Galliumantimonid-Basis aufgebaut sein.

Die aktive Schicht 40, der in der nachfolgenden detaillierten Beschreibung erläuterten GaAs/Al$_x$Ga$_{(1-x)}$As DFB Laserdiode mit lateraler Kopplung, weist zwei Quantenfilme auf.

Die obere Wellenleiterschicht 50 ist bei DFB Laserdioden mit lateraler Kopplung gemäß des Stands der Technik im Wesentlichen gleich dick und weist denselben Aluminiumanteil wie die untere Wellenleiterschicht 30 auf. Während die untere Wellenleiterschicht 30 mit Elementen dotiert sein kann, die Elektronen abgeben können (N-dotiert), kann die obere Wellenleiterschicht 50 mit Elementen dotiert sein, die Elektronen aufnehmen können (P-dotiert). Der Aluminiumanteil der unteren 30 und der oberen Wellenleiterschicht 50 kann über die Dicke der Schichten konstant sein. Es ist jedoch auch möglich, dass der Aluminiumanteil der Wellenleiterschichten 30, 50 in Richtung aktiven Schicht 40 abnimmt. Der Funktionsverlauf dieser Verringerung kann linear sein, so gewählt werden, dass eine GRINSCH (graded index separate confinement heterostructure) Struktur gebildet wird oder einer beliebig wählbaren Funktion folgen.

Analog der unteren Mantelschicht 20 folgt auf die obere Wellenleiterschicht 50 die obere Mantelschicht 60. Während die untere Mantelschicht 20 in der Regel N-dotiert ist, ist die obere Mantelschicht 60 normalerweise P-dotiert. Die Dicke, der Aluminiumanteil und der Betrag der Dotierung der oberen 60 und der unteren Mantelschicht 20 liegen in einem vergleichbaren Bereich.

Mit dem Abscheiden einer dünnen, sehr hoch dotierten GaAs Kontaktschicht 80 endet der Epitaxieprozess zum Herstellen von DFB Laserdioden mit lateraler Kopplung. Die Halbleitermaterialien zur Herstellung von DFB Laserdioden mit lateraler Kopplung werden somit in einem einzigen Epitaxieprozess hergestellt.

Wie in der Fig. 1 dargestellt, wird außerhalb des Wellenleiterstegs nach Beendigung des Expitaxieprozesses die obere Mantelschicht 60 zwischen den Laserspiegeln 90, 100 bis auf eine geringe Restdicke durch einen Ätzschritt entfernt. Der verbleibende zentrale Teil der oberen Mantelschicht 60 bildet den Wellenleitersteg 70.

Wie bereits oben erläutert, wird, um aus dem Spektrum des Fabry-Perot Laserresonators eine einzige Eigenschwingung auszuwählen, eine periodische Oberflächenstruktur 110 neben dem Wellenleitersteg 70 auf die verbleibende obere Mantelschicht 60 aufgebracht. Zwischen die obere Mantelschicht 60 und der periodischen Oberflächenstruktur 110 kann bedarfsweise eine in der Fig. 1 nicht dargestellte Passivierungsschicht aufgebracht werden. Die periodische Oberflächenstruktur 110 kann auf einer Seite des Wellenleiterstegs 70 oder beiderseits des Wcllcnlcitcrstcgs, wie in der Fig. 1 veranschaulicht, angeordnet werden. Die periodische Oberflächenstruktur 110 kann als eine streifenförmige Gitterstruktur ausgebildet sein und die Streifen können sich senkrecht zum Wellenleitersteg 70 erstrecken. Die Streifen der periodischen Oberflächenstruktur 110 umfassen ein Laserstrahlung absorbierendes Material, vorzugsweise ein Metall. Durch die Geometrie der Streifen und der Materialzusammensetzung der periodischen Oberflächenstruktur 110 kann das Ausmaß der Absorption der Laserstrahlung eingestellt werden.

Die periodische Oberflächenstruktur 110 kann sich entlang eines Teils der gesamten Länge des Wellenleiterstegs 70 erstrecken. Alternativ kann die periodische Oberflächenstruktur 110 sich entlang der gesamten Länge des Wellenleiterstegs 70 erstrecken. In einem weiteren alternativen Aspekt können die periodische Oberflächenstruktur und die aktive Schicht in longitudinaler Richtung räumlich getrennt von einander angeordnet sein.

Die aktive Schicht 40 weist einen höheren Brechungsindex als die untere 30 und die obere Wellenleiterschicht 50 auf. Ferner ist der Brechungsindex der Wellenleiterschichten 30, 50 größer als der Brechungsindex der Mantelschichten 20, 60. Aus dieser Brechungsindexverteilung resultiert eine Führung der Photonen innerhalb der Schichtenfolge 20 bis 60.

Die Fig. 2 zeigt einen zweidimensionalen Schnitt in der lateralen und transversalen Ebene der optischen Intensitätsverteilung auf einem der Laserspiegel 90, 100, der sich für eine DFB Laserdiode mit lateraler Kopplung und einer Wellenleiterschichtstruktur nach dem Stand der Technik ergibt. Dabei ist die Intensitätsverteilung so normiert, dass dem Maximum der Photonendichteverteilung der Wert 1 zugewiesen wurde. Die konzentrischen Kurven um den Punkt maximaler Intensität geben die Orte gleicher Photonendichte an. Die Dichte der optischen Intensität der äußersten Kurve beträgt noch 12,5 % des Maximalwerts. Die Variation der optischen Intensität zwischen dem maximalen Wert im Zentrum und der äußersten Kurve in Fig. 2 erfolgt linear. Diese Simulation wurde, wie alle nachfolgend dargestellten Simulationsergebnisse, mit einem pseudo-vektoriellen zweidimensionalen Modensolver durchgeführt.

In der hier beschriebenen GaAs/Al$_x$Ga$_{(1-x)}$As DFB Laserdiode mit lateraler Kopplung zeigt der Vektor des emittierten elektromagnetischen Feldes in laterale Richtung, d.h. es liegt TE-polarisierte (transversal elektrisch) Strahlung vor. Die erfindungsgemäßen Prinzipien können jedoch ebenso auf Laserdioden angewendet werden die TM-polarisiertes (transversal magnetisch) Licht emittieren, das beispielsweise durch Halbleiterlaser mit verspannten Quantenfilmen oder durch Quantenkaskadenlaser erzeugt werden kann.

Die Fig. 3 stellt einen eindimensionalen Schnitt in transversaler Richtung durch das Maximum der optischen Intensitätsverteilung der Fig. 2 dar. Wie aus der Fig. 2 ersichtlich und für die symmetrische Wellenleiterstruktur der Fig.

1 zu erwarten ist, ist die transversale Intensitätsverteilung symmetrisch zu der dünnen aktiven Schicht 40. Das Intensitätsmaximum der Lasermode befindet sich in der aktiven Schicht 40 und fällt in der unteren 30 und der oberen Wellenleiterschicht 50 steil ab, wodurch der größte Teil Intensität in dem Wellenleiterbereich in den Schichten 20, 30 und 40 geführt wird. Allerdings führen die untere 20 und die obere Mantelschicht 60 bzw. der Wellenleitersteg 70 signifikante Ausläufer der Photonenverteilung.

Die sehr hohen optischen Leistungsdichten in der Spitze der Verteilung stellen für die Laserspiegel 90, 100 eine enorme Belastung dar. Selbst bei einem Schutz der Laserspiegel 90, 100 durch eine dielektrische Vergütung begrenzt die optische Leistungsdichte die maximale Leistung, die über die Laserspiegel 90, 100 aus dem Laserresonator ausgekoppelt werden kann.

Ein quantitatives Maß, das die Verteilung des transversalen elektrischen Feldes charakterisiert, ist die effektive Modenfläche $A_{eff}$. Für eine Lasermode deren transversale elektrische Feldverteilung einer Gauß-Funktion folgt, d.h.

$$E_T(r) \propto \exp(-r^2/w_0^2)$$ ergibt sich für den der Zusammenhang zwischen wo und der effektiven Modenfläche $A_{eff}$ die

Beziehung: $$A_{eff} = \pi \cdot w_0^2.$$ Für die in den Figuren 2 und 3 dargestellte Intensitätsverteilung einer GaAs DFB Laserdiode mit lateraler Kopplung nach dem Stand der Technik ergibt sich eine effektive Modenfläche von $A_{eff} = 0{,}78~\mu m^2$.

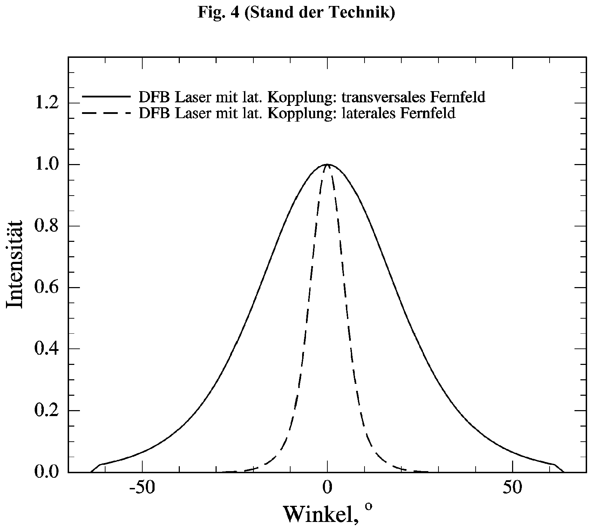

Die Fig. 4 stellt die Fernfeldverteilungen in lateraler und transversaler Richtung der zweidimensionalen optischen Intensitätsverteilung der Fig. 2 dar. Wie aus der Fig. 2 zu entnehmen ist, ist die Photonendichteverteilung in lateraler Richtung sehr viel ausgedehnter als in transversaler Richtung. Da die Abstrahlung der Lasermode von den Laserspiegeln 90, 100 im Wesentlichen beugungsbegrenzt erfolgt, spiegelt sich die asymmetrische optische Intensitätsverteilung auf den Laserspiegeln 90, 100 in stark unterschiedlichen Divergenzwinkeln des abgestrahlten Lichts in lateraler und transversaler Richtung wider. Zum Fokussieren dieses Strahlungsprofils sind aufwändige mehrteilige Optiken notwendig. Trotzdem bleibt für Elemente mit Rotationssymmetrie, wie beispielsweise Glasfasern, der Kopplungswirkungsgrad aufgrund der Ausläufer der Intensitätsverteilung bei sehr großen Winkeln begrenzt.

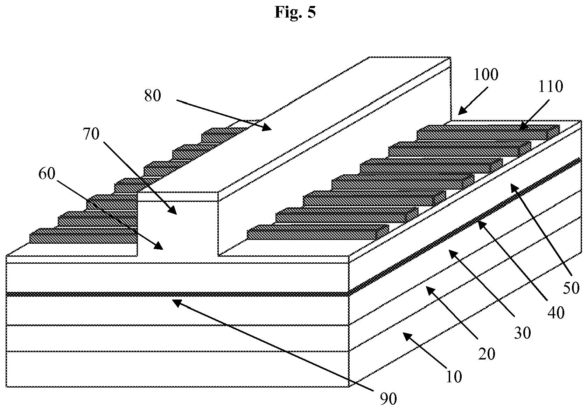

Die Fig. 5 zeigt die Schichtfolge der Fig. 1, wobei die Dicken der unteren 30 und der oberen Wellenleiterschicht 50 von etwa 0,2 μm auf jeweils etwa 1,0 μm vergrößert wurden, so dass die beiden Wellenleiterschichten 30, 50 eine sogenannte LOC (large optical cavity) bilden. Genauer handelt es sich um eine symmetrische LOC, da beide Wellenleiterschichten 30, 50 die gleiche Dicke aufweisen. An dem weiteren Aufbau der DFB Laserdiode mit lateraler Kopplung wurde gegenüber der Fig. 1 nichts weiter verändert. Wie bereits oben erläutert, kann auch für die Wellenleiterschichten 30, 50 der symmetrischen LOC der Aluminiumanteil über die Schichtdicke hinweg konstant sein oder es kann, wie oben beschrieben, der Aluminiumanteil in Richtung aktive Schicht 40 geringer werden.

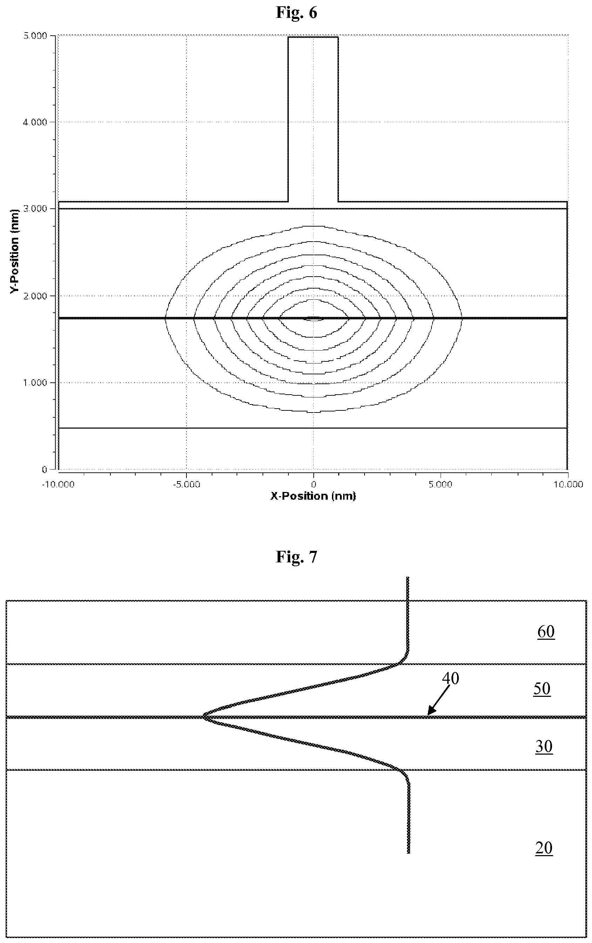

Die Fig. 6 zeigt wiederum einen zweidimensionalen Schnitt der simulierten optischen Intensitätsverteilung in der Ebene eines Laserspiegels 90, 100, die sich für eine DFB Laserdiode mit lateraler Kopplung und einer Wellenleiterschichtstruktur in Form einer symmetrischen LOC einstellt. Dem Vergleich der Figuren 2 und 6 kann unmittelbar entnommen werden, dass sich die Asymmetrie der Photonendichteverteilung in lateraler und transversaler Richtung durch die symmetrische LOC deutlich verringert hat. Dies ist im Wesentlichen auf eine deutliche Aufweitung der Lasermode in transversaler Richtung zurück zuführen. Der gegenüber dem Stand der Technik deutlich vergrößerte Zahlenwert der effektiven Modenfläche von 8,63 μm² spiegelt diesen Zusammenhang wider.

Diese Aussage wird ferner durch die Fig. 7 bestätigt. Diese stellt einen eindimensionalen Schnitt in transversaler Richtung durch das Maximum der optischen Intensitätsverteilung der Fig. 6 dar. Die Fig. 7 liefert im Wesentlichen zwei Ergebnisse: Im Vergleich zu der Fig. 3 ist in der Fig. 7 zum einen das Maximum der optischen Leistungsdichte geringer, $A_{eff}$ hat sich von 0,78 μm² auf 8,63 μm² vergrößert. Zum zweiten wird die Lasermode fast vollständig innerhalb der Wellenleiterschichten 30, 50 geführt.

Durch die Reduzierung der Spitze der maximalen optischen Leistungsdichte um mehr als einen Faktor 10 zwischen einer DFB Laserdiode mit lateraler Kopplung gemäß des Standes der Technik und mit einer symmetrischen LOC reduziert sich die Belastung der Laserspiegel 90, 100 entsprechend. Bei vorgegebener maximaler optischer Leistungsdichte kann damit die maximale über die Laserspiegel 90, 100 aus dem Laserresonator auskoppelbare Lichtleistung vergrößert werden, ohne dass Alterungsprozesse der Laserspiegel 90, 100 in Gang gesetzt werden, die zur Begrenzung der Lebensdauer der DFB Laserdiode mit lateraler Kopplung durch COD führen.

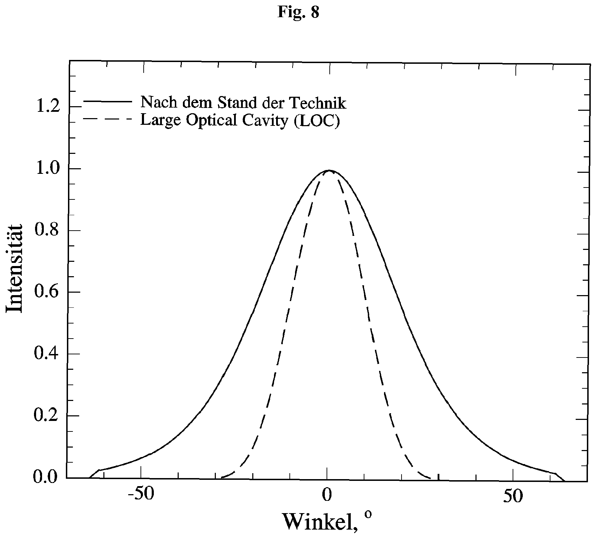

Die Fig. 8 stellt die Fernfeldverteilungen in transversaler Richtung der optischen Intensitätsverteilung der Figuren 3 und 7 einander gegenüber. Die Halbwcrtsbrcitc des Divergenzwinkels hat sich im Vergleich zum Stand der Technik in etwa halbiert. Damit hat sich auch die Asymmetrie der Strahlungsverteilung in lateraler und transversaler Richtung im Fernfeld der DFB Laserdiode mit lateraler Kopplung halbiert. Dies erleichtert das Einkoppeln des Strahlungsprofils beispielsweise in Glasfasern und erhöht gleichzeitig den Kopplungswirkungsgrad, da keine Strahlungsanteile bei sehr großen Divergenzwinkeln vorhanden sind.

Wie aus den Figuren 6 und 7 zu ersehen ist, weist die symmetrische LOC Struktur der Fig. 5 den schwerwiegenden Nachteil auf, dass durch die dicke obere Wellenleiterschicht 50 die Kopplung der Lasermode an die periodische Gitterstruktur 110 drastisch kleiner wird. Dies bedeutet, dass die Unterdrückung der unerwünschten Eigenschwingungen des Laserresonators, die innerhalb der Verstärkungsbandbreite des Materials der aktiven Schicht 40 liegen deutlich verringert wird, bzw. ganz verloren gehen kann. Die DFB Laserdiode mit lateraler Kopplung funktioniert in diesem Fall nicht länger als DFB Laser, sondern als Fabry-Perot Laserdiode, die Licht in mehreren Eigenschwingungen unterschiedlicher Wellenlänge emittiert.

Dieses Problem kann gelöst werden, indem die obere Wellenleiterschicht 50 sehr dünn ausgeführt wird. Dabei kann die Dicke der oberen Wellenleiterschicht auch kleiner als nach dem Stand der Technik ausgeführt werden (d ≤ 0,1 $\mu$m). Die untere Wellenleiterschicht 30 behält hingegen ihre Dicke (d ≈ 1,0 $\mu$m) bei, wie in Fig. 5 dargestellt. Alternativ kann die Dicke der unteren Wellenleiterschicht 30 so weit verbreitert werden, dass sie im Wesentlichen die Dicke der gesamten symmetrischen LOC der Fig. 5 umfasst (d ≈ 2, 5 $\mu$m). Die Dicke der unteren Wellenleiterschicht 30 kann auch alle Werte zwischen den beiden Alternativen annehmen. Der Aluminiumanteil und damit der Brechungsindex können wiederum, wie bereits oben erläutert, über die Schichtdicke konstant sein oder variieren.

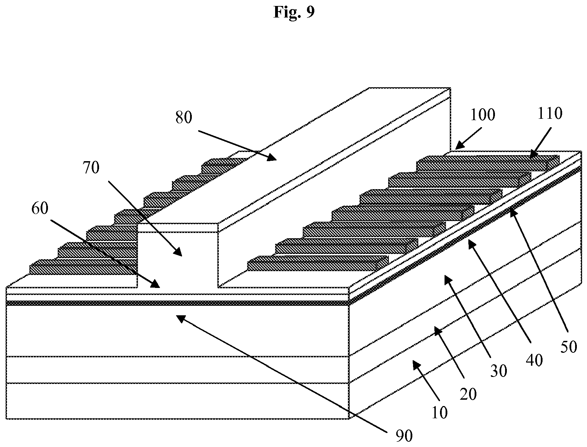

Die Fig. 9 zeigt die Schichtfolge der Fig. 5, wobei die Dicke der Wellenleiterschichten 30, 50 von etwa 1,0 $\mu$m auf etwa 25 nm für die obere Wellenleiterschicht 50 reduziert wurde und die der unteren Wcllcnlcitcrschicht 30 von etwa 1,0 $\mu$m auf etwa 2,5 $\mu$m vergrößert wurde, so dass sie eine stark asymmetrische LOC bilden. Die DFB Laserdiode mit lateraler Kopplung der Fig. 9 weist keine weiteren Änderungen gegenüber der Fig. 5 auf.

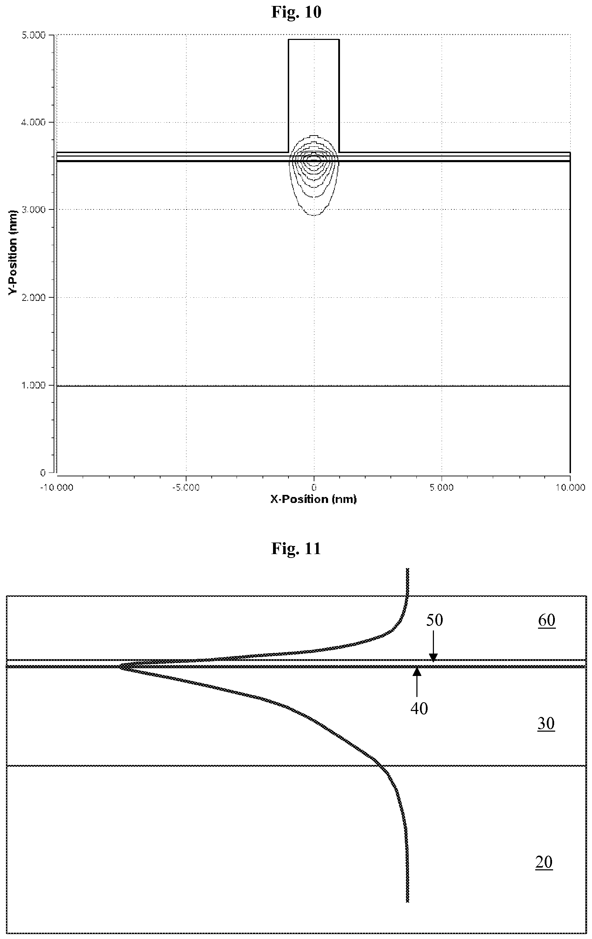

Die Fig. 10 zeigt wiederum einen zweidimensionalen Schnitt der simulierten optischen Intensitätsverteilung in der Ebene eines Laserspiegels 90, 100, die sich für eine DFB Laserdiode mit lateraler Kopplung und einer Wellenleiterschichtstruktur in Form einer asymmetrischen LOC ausbildet. Die asymmetrische LOC resultiert in einer asymmetrischen transversalen optischen Intensitätsverteilung bezüglich der aktiven Schicht 40. Die effektive Modenfläche dieser Struktur beträgt 0,63 $\mu$m$^2$ und ist damit geringer als jene der DFB Laserdioden gemäß dem Stand der Technik (A$_{eff}$ = 0,78 $\mu$m$^2$). Dies bedeutet die Verringerung der Dicke der oberen Wellenleiterschicht 50 über die Dicke des Standes der Technik hinaus in der gewählten asymmetrischen LOC kann durch die weitere Vergrößerung der Dicke der unteren Wellenleiterschicht 30 über den Zustand einer symmetrischen LOC hinaus bezüglich der effektiven Modenfläche nicht kompensiert werden. Der Vergleich der Figuren 6 und 10 zeigt deutlich, dass der Anteil der optischen Intensität, der bei der asymmetrischen LOC im Bereich des Wellenleiterstegs geführt wird, viel größer ist als bei der symmetrischen LOC der Fig. 6. Das oben beschriebene Problem der zu geringen Kopplung der Laserstrahlung an die periodische Gitterstruktur 110 vermeidet eine asymmetrische LOC zum großen Teil.

Die Fig. 11 gibt einen Schnitt in transversaler Richtung durch das Maximum der optischen Intensität wieder. Der größte Wert der optischen Leistungsdichte liegt noch immer in der aktiven Schicht 40. Die transversale Verteilung ist jedoch stark asymmetrisch und der Großteil der optischen Strahlung wird in der unteren Wellenleiterschicht 30 geführt. Der Strahlungsanteil in der unteren Mantelschicht 20 ist gering. Aufgrund der extrem dünnen oberen Wellenleiterschicht 50 ergibt sich in ihr ein sehr großer Gradient der Photonendichte. Die obere Mantelschicht 60 oder der Wellenleitersteg 70 führt einen Ausläufer der Intensitätsverteilung, der einen signifikanten Strahlungsanteil trägt. Wie bereits erwähnt, führt die asymmetrische LOC nochmals zu einer Verkleinerung der effektiven Modenfläche (A$_{eff}$ = 0,63 $\mu$m$^2$) im Vergleich zu DFB Laserdioden mit lateraler Kopplung nach dem Stand der Technik (A$_{eff}$ = 0,78 $\mu$m$^2$).

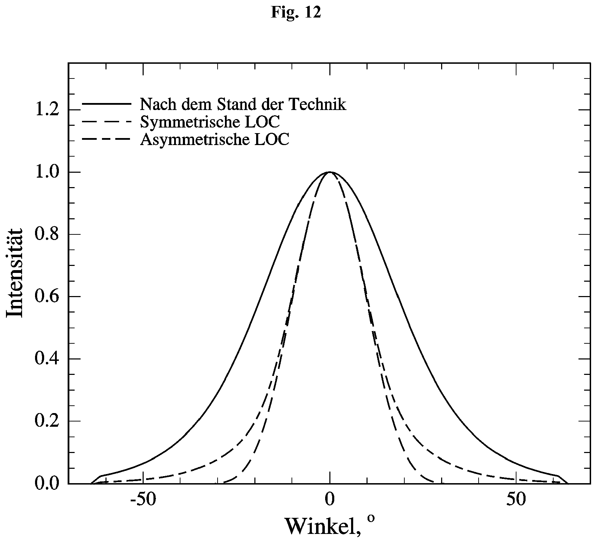

Die Fig. 12 stellt die Fernfeldverteilungen in transversaler Richtung der optischen Intensitätsverteilung der Figuren 3, 7 und 11 einander gegenüber. Die Halbwertsbreite der Divergenzwinkel der symmetrischen und der stark asymmetrischen LOC sind fast identisch, da die beiden Verteilungen oberhalb der 50 % Divergenzwinkel praktisch den gleichen Verlauf aufweisen. Allerdings zeigt die Intensitätsverteilung der Lasermode, die in der asymmetrischen LOC geführt wird, breitere Ausläufer als die Intensitätsverteilung der symmetrischen LOC.

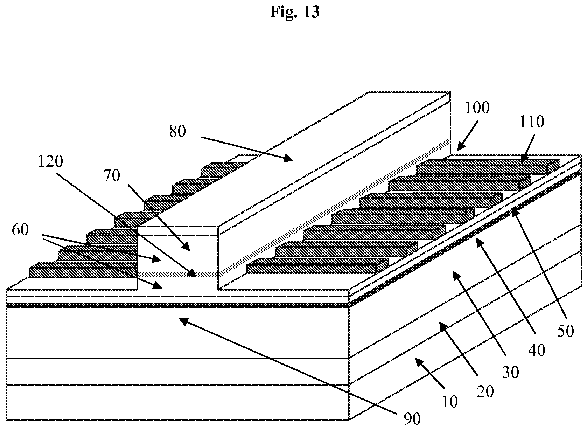

Die Figuren 10 und 11 zeigen, dass durch die asymmetrische LOC der Anteil der Lasermode der in dem Bereich der oberen Mantelschicht geführt wird im Vergleich zu der symmetrischen LOC deutlich ansteigt. Dies ermöglicht eine gewisse Überlappung der Lasermode mit der periodischen Oberflächenstruktur 110, der für das Funktionieren der lateralen Kopplung unerlässlich ist. Eine zusätzliche Möglichkeit die Kopplungsstärke der Lasermode an die periodische Oberflächenstruktur 110 zu beeinflussen und damit einzustellen, stellt die Ausbildung einer dünnen Schicht hohen Brechungsindexes 120 in dem Wellenleitersteg 70 oberhalb der periodischen Oberflächenstruktur 110 dar. Eine derartige Schicht ist in der Fig. 13 dargestellt. Im Übrigen ist die Fig. 13 mit der Fig. 9 identisch, die eine asymmetrische LOC wiedergibt.

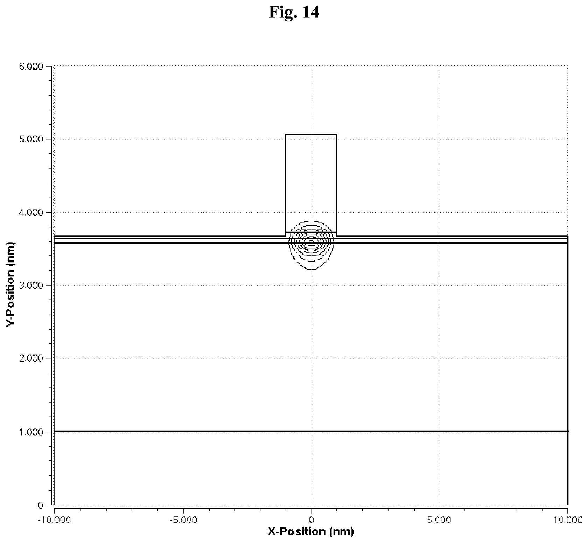

Die Fig. 14 zeigt den zweidimensionalen Schnitt der simulierten optischen Intensitätsverteilung in der Ebene eines Laserspiegels 90, 100 der Fig. 10, wobei zusätzlich in den Wellenleitersteg 70 eine Schicht mit hohem Brechungsindex 120, wie in Fig. 9 gezeigt, eingefügt wurde. Durch diese Schicht 120 verschiebt sich die optische Intensitätsverteilung etwas von der unteren Wellenleiterschicht 30 weg in die obere Mantelschicht 60 hinein. Wie aus dem Vergleich der Figuren 10 und 14 zu entnehmen ist, verringert die Wirkung der Schicht hohen Brechungsindexes 120 die bereits kleine effektive Modenfläche der asymmetrischen LOC (A$_{eff}$ = 0,63 $\mu$m$^2$) weiter. Die effektive Modenfläche der asymmetrischen LOC der Fig. 14 mit einer Schicht hohen Brechungsindexes 120 in der oberen Mantelschicht 60 oberhalb der periodischen Oberflächenstruktur 110 (Fig. 13) beträgt 0,43 $\mu$m$^2$.

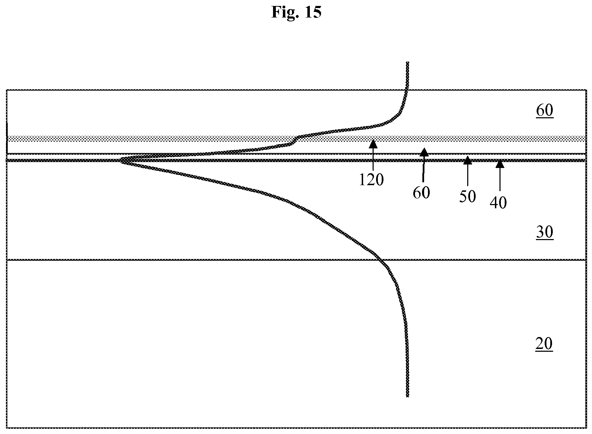

Wie der eindimensionale Schnitt der transversalen Intensitätsdichte der Fig. 15 zeigt, bewirkt die Schicht hohen Brechungsindexes 120 ein gewisses Anheben der optischen Leistungsdichte in dem Bereich des Wellenleiterstegs 70. Darüber hinaus bildet sich im Bereich der Schicht hohen Brechungsindexes 120 ein kleines Plateau in dem die optische Leistungsdichte nahezu konstant ist. Dies verbessert die Kopplung der Lasermode an die periodische Oberflächenstruktur 110 ohne die übrige optische Intensitätsverteilung wesentlich zu beeinflussen. Dadurch kann insbesondere für die asymmetrische LOC die Kopplungskonstante der periodischen Oberflächenstruktur verbessert werden. Die Anwendung einer dünnen Schicht hohen Brechungsindexes 120 in dem Wellenleitersteg 70 ist jedoch nicht auf eine asymmetrische LOC Struktur beschränkt. Diese Schicht kann ebenso auf DFB Laserdioden mit lateraler Kopplung nach dem Stand der Technik und auf solche mit einer symmetrischen LOC angewendet werden.

Die Schicht hohen Brechungsindexes 120 kann eine weiteres Problem, das bei der Herstellung von DFB Laserdioden auftreten kann, lösen bzw. zumindest deutlich entschärfen. Beim Abtragen der oberen Mantelschicht 60 außerhalb des Wellenleiterstegs 70 können aufgrund von Schwankungen im Ätzprozess, der zum Entfernen der oberen Mantelschicht 60 eingesetzt wird, unterschiedliche verbleibende Restdicken der oberen Mantelschicht 60 außerhalb des Wellenleiterstegs 70 auftreten. Wie die Figuren 3 und 11 zeigen, ändert sich der Ausläufer der optischen Intensitätsverteilung in diesem Bereich sehr stark. Eine Schicht hohen Brechungsindexes 120 kann eingesetzt werden, um die dadurch verursachten Variationen der Kopplungskonstante an die periodische Oberflächenstruktur 110 zumindest teilweise zu kompensieren.

Wie der Fig. 12 zu entnehmen ist, weist die asymmetrische LOC der Figuren 9 und 13 bei großen Divergenzwinkeln größere Intensitätsanteile auf als die symmetrische LOC. Im Vergleich zu den transversalen Fernfeldern herkömmlicher Strukturen nach dem Stand der Technik ist das Fernfeld jedoch signifikant weniger divergent, so dass eine leichtere Einkopplung in Optiken möglich ist.

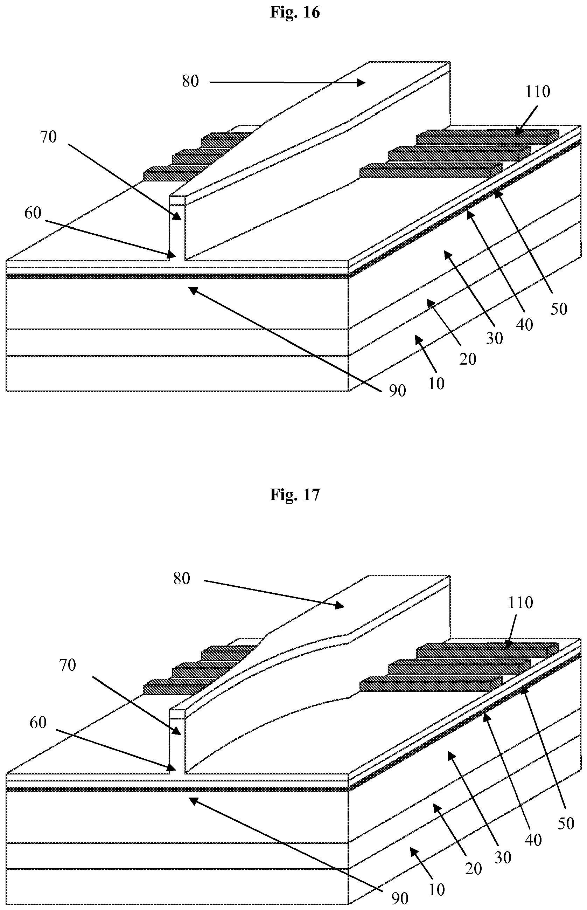

Ein Problem stellen die außer bei der symmetrischen LOC Struktur (Fig. 5) noch immer sehr großen maximalen optischen Leistungsdichten in den Spitzen der Intensitätsverteilungen der Fig. 3, 7, 11 und 15 dar. Quantitativ lässt sich dieser Zusammenhang an den effektiven Modenflächen der bisher diskutierten verschiedenen Wellenleiterstrukturen festmachen. Die Figuren 16 und 17 zeigen Möglichkeiten auf, wie dieses Problem gelöst werden kann.

Die Fig. 16 zeigt einen Teil der asymmetrischen LOC Struktur der Fig. 9 bei der sich der Wellenleitersteg 70 linear in Richtung auf einen Laserspiegel 90, 100 verjüngt. In der Fig. 17 folgt die Verringerung der Breite des Wellenleiterstegs 70 einer Exponentialfunktion. Diese beiden Figuren zeigen lediglich Beispiele der Verjüngung des Wellenleiterstegs 70. So kann sich der Wellenleitersteg 70 nach einer beliebigen nichtlinearen Funktion verjüngen oder beispielsweise in Stufen. Ferner kann die Verringerung der Breite des Wellenleiterstegs 70 nur auf einer Seite erfolgen. So kann neben der in den Figuren 16 und 17 gezeigten symmetrischen Verjüngung bezüglich der Längsachse des Wellenleiterstegs, ebenso eine asymmetrische Verjüngung zu beiden Seiten des Wellenleiterstegs 70 ausgeführt werden, wobei die Verjüngung auf beiden Seiten der gleichen oder einer verschiedenen funktionalen Abhängigkeit folgen kann.

Die Verjüngung oder das Tapern des Wellenleiterstegs kann in Richtung eines Laserspiegels 90 oder 100 oder in Richtung beider Laserspiegel 90 und 100 erfolgen. Dabei kann das Verjüngen in Richtung der beiden Laserspiegel 90, 100 gleich oder verschieden ausgeführt werden.

Die Metallisierung der Kontaktschicht 80 kann sich über den gesamten Bereich erstrecken in dem sich die Breite des Wellenleiterstegs 70 ändert. Alternativ kann die Metallisierung der Kontaktschicht 80 sich über einen Teil des Bereichs erstrecken in dem sich die Breite des Wellenleiterstegs 70 ändert; oder die Metallisierung der Kontaktschicht 80 kann sich nicht über den Bereich erstrecken in dem sich die Breite des Wellenleiterstegs 70 ändert. Es ist ferner denkbar, dass die Metallisierung der Kontaktschicht 80 über die Breite des Wellenleiterstegs 70 an der Position unterbrochen ist, an der die Verkleinerung der Breite des Wellenleiterstegs 70 beginnt.

Die Figuren 16 und 17 weisen keine periodische Oberflächenstruktur 110 in dem Verjüngungsbereich auf. Die periodische Oberflächenstruktur 110 kann sich jedoch auch in den Bereich der Verjüngung hinein fortsetzen. Dabei kann deren Periodizität an die jeweilige Breite des Wellenleiterstegs 70 angepasst werden. Alternativ kann die Periode des Bereichs konstanter Wellenleiterstegbreite in den Verjüngungsbereich hinein fortgesetzt werden.

Alternativ zu einer Reduzierung der Breite des Wellenleiterstegs 70 wie in den Figuren 15 und 16 dargestellt, kann zur Erzielung der gleichen Wirkung eine Verringerung der Höhe des Wellenleiterstegs 70 durchgeführt werden. Ferner kann eine Kombination einer Verjüngung der Breite und eine Verringerung der Höhe des Wellenleiterstegs 70 vorteilhaft eingesetzt werden.

Die Verjüngung des Wellenleiterstegs 70 wurde in dem Kontext einer asymmetrischen LOC diskutiert. Eine LOC ist jedoch für die Anwendung einer Verringerung der Breite des Wellenleiterstegs nicht notwendig. Dieses Prinzip kann auch für eine DFB Laserdiode gemäß des Standes der Technik eingesetzt werden.

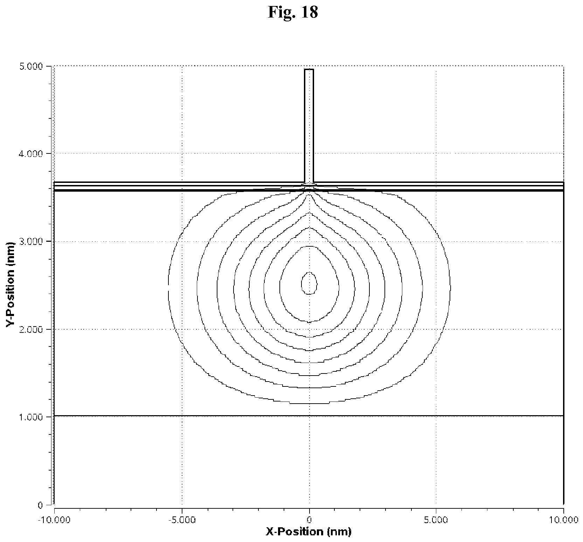

Die Fig. 18 zeigt einen zweidimensionalen Schnitt der simulierten optischen Intensitätsverteilung in der Ebene eines Laserspiegels 90, 100, die sich für eine DFB Laserdiode mit lateraler Kopplung mit einer asymmetrischen LOC und einer Verjüngung des Wellenleiterstegs 70 nach einer der Figuren 16 oder 17 ausbildet. Die Breite des Wellenleiterstegs 70 wurde von etwa 2,0 μm auf etwa 0,3 μm auf dem Laserspiegel 90, 100 verringert. Generell wird ein Wellenleitersteg 70 so ausgeführt, dass seine Breite einige Wellenlängen der emittierten Strahlung in dem Halbleitermaterial beträgt. Am Ende der Taperung verringert sich die Breite des Wellenleiterstegs 70 auf etwa die Wellenlänge des Laserlichts in dem Laserresonator.

Die Lasermode weicht der Einschnürung in dem Wellenleitersteg 70 nach unten aus und füllt auf dem Laserspiegel im Wesentlichen die gesamte untere Wellenleiterschicht 30. Die effektive Modenfläche hat sich gegenüber der asymmetrischen LOC durch die Taperung des Wellenleiterstegs 70 um etwa den Faktor 17 auf $A_{eff}$ = 10,74 $\mu m^2$ vergrößert. Damit ist die effektive Modenfläche der asymmetrischen LOC mit Taperung insbesondere größer als die effektive Modenfläche der symmetrischen LOC ($A_{eff}$ = 8,63 $\mu m^2$). Verglichen mit einer DFB Laserdiode mit lateraler Kopplung nach dem Stand der Technik ($A_{eff}$ = 0,78 $\mu m^2$) weist eine DFB Laserdiode mit lateraler Kopplung mit asymmetrischer LOC und einer Taperung eine etwa vierzehnfach vergrößerte effektive Modenfläche auf. Durch die drastische Aufweitung der Lasermode an dem Laserspiegel 90 reduziert sich die maximale optische Leistungsdichte um etwa eine Größenordnung. Dies erlaut eine entsprechende Steigerung der durch den Laserspiegel 90, 100 auskoppelbaren Lichtleistung.

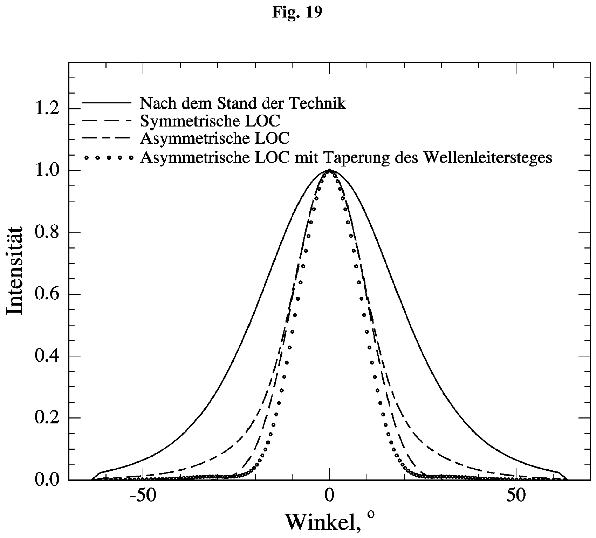

Die Fig. 19 stellt die Fernfeldverteilungen in transversaler Richtung der optischen Intensitätsverteilung einer DFB Laserdiode mit lateraler Kopplung nach dem Stand der Technik (Fig. 1), mit symmetrischer LOC (Fig. 5), mit asymmetrischer LOC (Fig. 9) und mit asymmetrischer LOC und einer zusätzlichen Verjüngung des Wellenleiterstegs 70 (Figuren 16 und 17) vergleichend einander gegenüber. Die Halbwertsbreite des Divergenzwinkels der asymmetrischen LOC mit Taperung ist nochmals geringer als der Divcrgcnzwinkcl der symmetrischen LOC. Damit haben sich die Divergenzwinkel der lateralen und der vertikalen Fernfeldverteilungen für die asymmetrische LOC mit zusätzlicher Taperung weitgehend angeglichen. Dies ermöglicht, dass die aufgrund der Verjüngung des Wellenleiterstegs 70 stark erhöhte auskoppelbare Lichtleistung ohne großen Aufwand mit großem Wirkungsgrad in rotationssymmetrische optische Elemente, wie etwa Glasfasern, eingekoppelt werden kann.

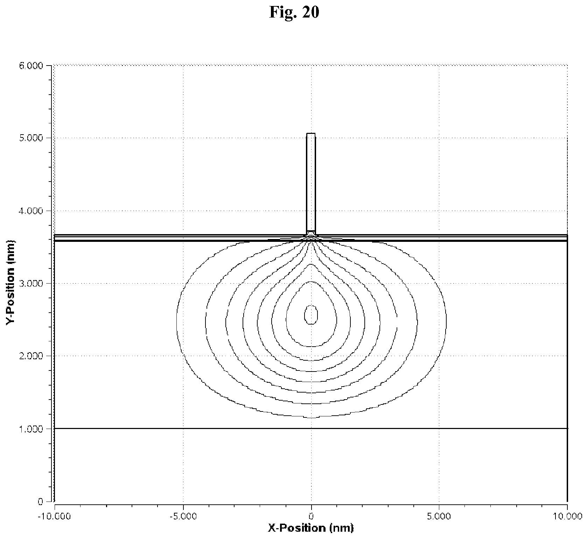

Wie bereits anhand der Figuren 14 und 15 erläutert, ermöglicht eine dünne Schicht hohen Brechungsindexes 120 in dem Wellenleitersteg 70 oberhalb der periodischen Gitterstruktur 110 den Kopplungsfaktor der Lasermode an die periodische Struktur 110 zu erhöhen und damit das Unterdrückungsverhältnis unerwünschter Eigenschwingungen zu vergrößern. Die Fig. 20 zeigt den zweidimensionalen Schnitt der simulierten optischen Intensitätsverteilung in der Ebene eines Laserspiegels 90, 100 der Fig. 18 bei der zusätzlich eine Schicht hohen Brechungsindexes 120 in den Wellenleitersteg 70 eingefügt wurde. Aus dem Vergleich der Figuren 18 und 20 wird ersichtlich, dass diese Schicht 120 ein gewisses Anheben der optischen Intensität im Bereich des Wellenleiterstegs 70 und beiderseits davon bewirkt. Die Verschlechterung der Intensitätsverteilung auf dem Laserspiegel 90, 100, ausgedrückt in der Verringerung der effektiven Modenfläche hält sich mit einer Verringerung um weniger als 8 % bezogen auf eine asymmetrische LOC mit Taperung auf $A_{eff}$ = 9,96 $\mu m^2$ jedoch in Grenzen. Damit vereinigt die Kombination einer asymmetrischen LOC mit einer Taperung des Wellenleiterstegs 70 und einer Schicht hohen Brechungsindexes 120 das gleichzeitige Erreichen eines ausreichenden Kopplungswirkungsgrads zwischen der Lasermode und der periodischen Oberflächenstruktur 110 und einer großen effektiven Modenfläche. Ein großer Zahlenwert der letztgenannten Größe ist eine wesentliche Vorraussetzung für große über den Laserspiegel 90, 100 auskoppelbare Lichtleistungen.

Die Verschiebung und Aufweitung der Lasermode erfolgt nur im Bereich des sich verjüngenden Wcllcnlcitcrstcgs 70. Wie den Figuren 2 und 3, 10 und 11 sowie 15 und 16 zu entnehmen ist, stellen sich im Innern des Laserresonators im Wesentlichen Intensitätsverteilungen ein, deren Intensitätsmaximum im Bereich der aktiven Schicht 40 liegt. Wie aus der nachfolgenden Tabelle 1 ersichtlich ist, ist die effektive Modenfläche der gewählten asymmetrischen LOC und der asymmetrischen LOC mit einer Schicht großen Brechungsindexes 120 kleiner als die einer DFB Laserdiode mit lateraler Kopplung nach dem Stand der Technik. Somit wird der Confinement-Faktor der Lasermode in dem Verstärkungsbereich der aktiven Schicht 40 im Innern des Laserresonators nicht merklich geändert. Damit ändert keines der vorgestellten erfindungsgemäßen Prinzipien die wesentlichen Kenngrößen von DFB Laserdioden mit lateraler Kopplung in signifikanter Weise.

Die folgende Tabelle fasst die effektiven Modenflächen der diskutierten erfindungsgemäßen Prinzipien zusammen.

Tabelle 1: Vergleich der effektiven Modenflächen verschiedener erfindungsgemäßer Prinzipien

| Struktur | $A_{eff}$ [$\mu m^2$] | Bezug |
|---|---|---|
| Stand der Technik | 0,78 | Fig. 2 |
| Symmetrische LOC | 8,63 | Fig. 6 |
| Asymmetrische LOC | 0,63 | Fig. 10 |
| Asymmetrische LOC + Schicht 120 | 0,43 | Fig. 14 |
| Asymmetrische LOC + Taperung | 10,74 | Fig. 18 |
| Asymmetrische LOC + Schicht 120 + Taperung | 9,96 | Fig. 20 |

In der nachfolgenden Tabelle wird beispielhaft die Schichtfolge einer GaAs/$Al_xGa_{(1-x)}$As DFB Laserdiode mit lateraler Kopplung dargestellt, die die beiden erfindungsgemäßen Prinzipien asymmetrische LOC und Schicht mit hohem Brechungsindex 120 in einem Epitaxieprozess verwirklicht.

Tabelle 2: Schichtaufbau einer DFB Laserdiode mit lateraler Kopplung mit asymmetrischer LOC und einer Schicht hohen Brechungsindexes

| Funktion | Dicke | Material | Al-Anteil | Dotierung | Typ |
|---|---|---|---|---|---|
| | [nm] | | [%] | [$cm^{-3}$] | |
| Kontaktschicht 80 | 150 | GaAs | --- | $1 \cdot 10^{20}$-$1 \cdot 10^{19}$ | P |
| Obere Mantelschicht 60 | 100 | $Al_xGa_{(1-x)}$As | x =0,34 | $1 \cdot 10^{19}$-$5 \cdot 10^{18}$ | P |
| | 1250 | $Al_xGa_{(1-x)}$As | x =0,34 | $5 \cdot 10^{18}$ - $1 \cdot 10^{17}$ | P |
| | 100 | $Al_xGa_{(1-x)}$As | x =0,34 | $1 \cdot 10^{17}$ | P |
| | 25 | $Al_xGa_{(1-x)}$As | $0,34 \geq x \geq 0$ | $1 \cdot 10^{17}$ | P |
| Schicht 120 | 50 | GaAs | - | $1 \cdot 10^{17}$ | P |
| Obere Mantelschicht 60 | 25 | $Al_xGa_{(1-x)}$As | $0 \leq x \leq 0,34$ | $1 \cdot 10^{17}$ | P |
| | 250 | $Al_xGa_{(1-x)}$As | x =0,34 | $1 \cdot 10^{17}$ | P |
| Obere Wellenl. 50 | 25 | $Al_xGa_{(1-x)}$As | $0,34 \geq x \geq 0$ | intrinsisch | --- |
| Aktive Schicht 40 | 10 | GaAs | --- | intrinsisch | --- |
| | 8 | Quantenfilm | | | |
| | 10 | GaAs | --- | intrinsisch | --- |
| | 8 | Quantenfilm | | | |
| | 10 | GaAs | --- | intrinsisch | --- |
| Untere Wellenl. 30 | 25 | $Al_xGa_{(1-x)}$As | $0 \leq x \leq 0,24$ | intrinsisch | --- |
| | 25 | $Al_xGa_{(1-x)}$As | x =0,24 | $1 \cdot 10^{17}$ | N |
| | 2000 | $Al_xGa_{(1-x)}$As | x =0,24 | $1 \cdot 10^{17}$-$5 \cdot 10^{17}$ | N |
| Untere Mantels. 20 | 1000 | $Al_xGa_{(1-x)}$As | x =0,35 | $1 \cdot 10^{18}$ | N |
| Substrat 10 | | | | | |

**Patentansprüche**

1. DFB Laserdiode mit lateraler Kopplung, aufweisend:

    a. zumindest ein Halbleitersubstrat (10);
    b. zumindest eine auf dem Halbleitersubstrat angeordnete aktive Schicht (40);
    c. zumindest einen oberhalb der aktiven Schicht (40) angeordneten Wellenleitersteg (70);
    d. zumindest eine neben dem Wellenleitersteg (70) oberhalb der aktiven Schicht (40) angeordnete periodische Oberflächenstruktur (110), wobei die periodische Oberflächenstruktur (110) nach einem Ätzprozess auf die verbleibende obere Mantelschicht (60) aufgebracht wird;
    **dadurch gekennzeichnet, dass**
    e. zumindest eine unterhalb und oberhalb der aktiven Schicht (40) angeordnete Wellenleiterschicht (30, 50), wobei die untere Wellenleiterschicht (30) eine Dicke im Bereich von 1 $\mu$m bis 5 $\mu$m, bevorzugt 1,5 $\mu$m bis 3 $\mu$m und besonders bevorzugt von 2,0 $\mu$m bis 2,5 $\mu$m aufweist und die obere Wellenleiterschicht (50) eine Dicke im Bereich von 15 nm bis 100 nm und bevorzugt von 20 nm bis 50 nm aufweist.

2. DFB Laserdiode gemäß Anspruch 1, wobei die Brechungsindexdifferenz zwischen der aktiven Schicht (40) und der Wellenleiterschicht (30, 50) in einem Bereich von 0,04 bis 0,40, bevorzugt von 0,06 bis 0,30 und besonders bevorzugt von 0,08 bis 0,25 liegt.

3. DFB Laserdiode gemäß einem der Ansprüche 1 oder 2, wobei der Brechungsindex der Wellenleiterschicht (30, 50) über die Schichtdicke konstant ist.

4. DFB Laserdiode gemäß einem der Ansprüche 1 - 3, wobei der Brechungsindex der Wellenleiterschicht (30, 50) sich über die Schichtdicke ändert, vorzugsweise linear.

5. DFB Laserdiode gemäß einem der Ansprüche 1 - 4, wobei der Querschnitt des Wellenleiterstegs (70), vorzugsweise dessen Breite, in Richtung zumindest eines Laserspiegels (90, 100) kleiner wird.

6. DFB Laserdiode gemäß Anspruch 5, wobei die Breite des Wellenleiterstegs (70) in Richtung zumindest eines Laserspiegels (90, 100) linear kleiner wird.

7. DFB Laserdiode gemäß einem der Ansprüche 5 oder 6, wobei die Breite des Wellenleiterstegs (70) in Richtung zumindest eines Laserspiegels (90, 100) exponentiell kleiner wird.

8. DFB Laserdiode gemäß einem der Ansprüche 5 - 7, wobei der Wellenleitersteg (70) eine Breite im Bereich von 0,5 $\mu$m bis 10 $\mu$m, bevorzugt von 2 $\mu$m bis 7 $\mu$m und besonders bevorzugt von 2 $\mu$m bis 4 $\mu$m aufweist.

9. DFB Laserdiode gemäß einem der Ansprüche 5 - 8, wobei der Wellenleitersteg (70) an zumindest einem Laserspiegel (90, 100) eine Breite im Bereich von 100 nm bis 700 nm und bevorzugt von 200 nm bis 500 nm aufweist.

10. DFB Laserdiode gemäß einem der Ansprüche 5 - 9, wobei die Verkleinerung der Breite des Wellenleiterstegs (70) in Richtung zumindest eines Laserspiegels (90, 100) über eine Länge im Bereich von 50 $\mu$m bis 1000 $\mu$m, bevorzugt von 100 $\mu$m bis 600 $\mu$m und besonders bevorzugt von 200 $\mu$m bis 400 $\mu$m erfolgt.

11. DFB Laserdiode gemäß einem der Ansprüche 5 - 10, wobei die Breite des Wellenleiterstegs (70) in Richtung beider Laserspiegel (90, 100) kleiner wird.

12. DFB Laserdiode gemäß einem der Ansprüche 5 - 11, wobei die Verkleinerung der Breite des Wellenleiterstegs (70) in Richtung der beiden Laserspiegel (90, 100) bezüglich einer longitudinalen und/oder einer lateralen Richtung asymmetrisch erfolgt.

13. DFB Laserdiode gemäß einem der Ansprüche 5 - 12, wobei die periodische Oberflächenstruktur (110) sich nicht entlang des Bereichs erstreckt, in dem sich der Querschnitt des Wellenleiterstegs (70) ändert.

14. DFB Laserdiode gemäß einem der vorangehenden Ansprüche, ferner aufweisend eine in dem Wellenleitersteg (70) angeordnete Schicht, deren Brechungsindex (120) größer als der Brechungsindex des Wellenleiterstegs (70) ist.

15. DFB Laserdiode gemäß Anspruch 14, wobei die Schicht hohen Brechungsindexes (120) oberhalb der periodischen Oberflächenstruktur (110) angeordnet ist.

16. DFB Laserdiode gemäß einem der Ansprüche 14 oder 15, wobei die Brechungsindexdifferenz zwischen der Schicht hohen Brechungsindexes (120) und des Wellenleiterstegs (70) in einem Bereich von 0,10 bis 0,40, bevorzugt von 0,15 bis 0,35 und besonders bevorzugt von 0,20 bis 0,30 liegt.

17. DFB Laserdiode gemäß einem der Ansprüche 14 - 16, wobei die Dicke der Schicht hohen Brechungsindexes (120) im Bereich ≤ 5 % der Dicke des Wellenleiterstegs (70) liegt.

**Claims**

1. DFB laser diode with lateral coupling, comprising:

    a. at least one semiconductor substrate (10);
    b. at least one active layer (40) disposed on the semiconductor substrate;
    c. at least one waveguide web (70) disposed above the active layer (40);
    d. at least one periodic surface structure (110) disposed above the active layer (40) adjacent the waveguide web (70), the periodic surface structure (110) being applied to the remaining upper cladding layer (60) after an etching process;

**characterized in that**

e. at least one waveguide layer (30, 50) disposed below and above the active layer (40), wherein the lower waveguide layer (30) has a thickness in the range from 1 $\mu m$ to 5 $\mu m$, preferably 1.5 $\mu m$ to 3 $\mu m$ and most preferably from 2.0 $\mu m$ to 2.5 $\mu m$ and the upper waveguide layer (50) has a thickness in the range from 15 nm to 100 nm and preferably from 20 nm to 50 nm.

2.  DFB laser diode according to claim 1, wherein the refractive index difference between the active layer (40) and the waveguide layer (30, 50) ranges from 0.04 to 0.40, preferably from 0.06 to 0.30 and most preferably from 0.08 to 0.25.

3.  DFB laser diode of any of claims 1 or 2, wherein the refractive index of the waveguide layer (30, 50) is constant over the layer thickness.

4.  DFB Laser diode of any of claims of 1 - 3, where the refractive index of the waveguide layer (30, 50) changes over the layer thickness, preferably linearly.

5.  DFB Laser diode of any of claims 1 - 4, wherein the cross-section of the waveguide web (70), preferably its width, becomes smaller in the direction of at least one laser mirror (90, 100).

6.  DFB laser diode according to claim 5, wherein the width of the waveguide web (70) becomes linearly smaller in the direction of at least one laser mirror (90, 100).

7.  DFB Laser diode of any of claims 5 or 6, wherein the width of the waveguide web (70) becomes exponentially smaller in the direction of at least one laser mirror (90, 100).

8.  DFB laser diode of any of claims 5 - 7, wherein the waveguide web (70) has a width in the range from 0.5 $\mu m$ to 10 $\mu m$, preferably from 2 $\mu m$ to 7 $\mu m$ and most preferably from 2 $\mu m$ to 4 $\mu m$.

9.  DFB Laser diode of any of claims 5 - 8, wherein the waveguide web (70) on at least one laser mirror (90, 100) has a width in the range from 100 nm to 700 nm and preferably from 200 nm to 500 nm.

10. DFB Laser diode of any of claims 5 - 9, wherein the reduction of the width of the waveguide web (70) in the direction of at least one laser mirror (90, 100) takes place over a length in the range from 50 $\mu m$ to 1000 $\mu m$, preferably from 100 $\mu m$ to 600 $\mu m$ and most preferably from 200 $\mu m$ to 400 $\mu m$.

11. DFB laser diode of any of claims 5 - 10, wherein the width of the waveguide web (70) becomes smaller in the direction of both laser mirrors (90, 100).

12. DFB Laser diode of any of claims 5 - 11, wherein the reduction of the width of the waveguide web (70) in the direction of the two laser mirrors (90, 100) is asymmetrical with respect to a longitudinal and/or a lateral direction.

13. DFB laser diode of any of claims 5-12, wherein the periodic surface structure (110) does not extend along the region in which the cross-section of the waveguide web (70) is changing.

14. DFB laser diode of one of the preceding claims, further comprising a layer disposed in the waveguide web (70) whose refractive index (120) is greater than the refractive index of the waveguide web (70).

15. DFB laser diode according to claim 14, wherein the high refractive index layer (120) is disposed above the periodic surface structure (110).

16. DFB laser diode of any of Claims 14 or 15, wherein the refractive index difference between the high refractive index layer (120) and the waveguide web (70) is in a range of 0.10 to 0.40, preferably from 0.15 to 0.35 and most preferably from 0.20 to 0.30.

17. DFB laser diode of any of claims 14-16, wherein the thickness of the high refractive index layer (120) is in the range $\leq$ 5 % of the thickness of the waveguide web (70).

**Revendications**

1. Diode laser DFB à couplage latéral comprenant :

   a. au moins un substrat semi-conducteur (10) ;
   b. au moins une couche active (40) disposée sur le substrat semi-conducteur ;
   c. au moins une traverse de guide d'ondes (70) disposée au-dessus de la couche active (40) ;
   d. au moins une structure superficielle périodique (110) disposée à côté de la traverse de guide d'ondes (70), au-dessus de la couche active (40), la structure superficielle périodique (110) étant appliquée, après le processus d'attaque, sur la couche d'enveloppe supérieure restante (60) ;

   **caractérisée par**

   e. au moins une couche de guide d'ondes (30, 50) disposée au-dessous et au-dessus de la couche active (40), la couche de guide d'ondes intérieure (30) présentant une épaisseur située dans plage de 1 $\mu$m à 5 $\mu$m, préférentiellement de 1,5 $\mu$m à 3 $\mu$m et particulièrement préférentiellement de 2,0 $\mu$m à 2,5 $\mu$m, et la couche de guide d'ondes supérieure (50) présentant une épaisseur située dans la plage de 15 nm à 100 nm et préférentiellement de 20 nm à 50 nm.

2. Diode laser DFB selon la revendication 1, dans laquelle la différence d'indice de réfraction entre la couche active (40) et la couche de guide d'ondes (30, 50) se situe dans une plage de 0,04 à 0,40, préférentiellement de 0,06 à 0,30 et particulièrement préférentiellement de 0,08 à 0,25.

3. Diode laser DFB selon l'une des revendications 1 ou 2, dans laquelle l'indice de réfraction de la couche de guide d'ondes (30, 50) est constant sur l'épaisseur de couche.

4. Diode laser DFB selon l'une des revendications 1 à 3, dans laquelle l'indice de réfraction de la couche de guide d'ondes (30, 50) varie, de préférence linéairement, sur l'épaisseur de la couche.

5. Diode laser DFB selon l'une des revendications 1 à 4, dans laquelle la section transversale de la traverse de guide d'ondes (70), de préférence sa largeur, diminue en direction d'au moins un miroir de laser (90, 100).

6. Diode laser DFB selon la revendication 5, dans laquelle la largeur de la traverse de guide d'ondes (70) diminue linéairement en direction d'au moins un miroir de laser (90, 100).

7. Diode laser DFB selon l'une des revendications 5 ou 6, dans laquelle la largeur de la traverse de guide d'ondes (70) diminue exponentiellement en direction d'au moins un miroir de laser (90, 100).

8. Diode laser DFB selon l'une des revendications 5 à 7, dans laquelle la traverse de guide d'ondes (70) présente une largeur située dans la plage de 0,5 $\mu$m à 10 $\mu$m, préférentiellement de 2 $\mu$m à 7 $\mu$m et en particulier préféré de 2 $\mu$m à 4 $\mu$m.

9. Diode laser DFB selon l'une des revendications 5 à 8, dans laquelle la traverse de guide d'ondes (70) présente, au niveau d'au moins un miroir de laser (90, 100), une largeur située dans la plage de 100 nm à 700 nm et préférentiellement de 200 nm à 500 nm.

10. Diode laser DFB selon l'une des revendications 5 à 9, dans laquelle la diminution de la largeur de la traverse de guide d'ondes (70) en direction d'au moins un miroir de laser (90, 100) s'effectue sur une longueur située dans la plage de 50 $\mu$m à 1000 $\mu$m, préférentiellement de 100 $\mu$m à 600 $\mu$m et particulièrement préférentiellement de 200 $\mu$m à 400 $\mu$m.

11. Diode laser DFB selon l'une des revendications 5 à 10, dans laquelle la largeur de la traverse de guide d'ondes (70) diminue en direction des deux miroirs de laser (90, 100).

12. Diode laser DFB selon l'une des revendications 5 à 11, dans laquelle la diminution de la largeur de la traverse de guide d'ondes (70) en direction des deux miroirs de laser (90, 100) s'effectue de manière asymétrique par rapport à une direction longitudinale et/ou à une direction latérale.

**13.** Diode laser DFB selon l'une des revendications 5 à 12, dans laquelle la structure superficielle périodique (110) ne s'étend pas le long de la zone dans laquelle la section transversale de la traverse de guide d'ondes (70) varie.

**14.** Diode laser DFB selon l'une des revendications précédentes, comprenant en outre une couche qui est disposée dans la traverse de guide d'ondes (70) et dont l'indice de réfraction (120) est supérieur à l'indice de réfraction de la traverse de guide d'ondes (70).

**15.** Diode laser DFB selon la revendication 14, dans laquelle la couche à haut indice de réfraction (120) est disposée au-dessus de la structure superficielle périodique (110).

**16.** Diode laser DFB selon l'une des revendications 14 ou 15, dans laquelle la différence d'indice de réfraction entre la couche à haut indice de réfraction (120) et la traverse de guide d'ondes (70) se situe dans une plage de 0,10 à 0,40, préférentiellement de 0,15 à 0,35 et particulièrement préférentiellement de 0,20 à 0,30.

**17.** Diode laser DFB selon l'une des revendications 14 à 16, dans laquelle l'épaisseur de la couche à haut indice de réfraction (120) se situe dans la plage $\leq$ 5 % de l'épaisseur de la traverse de guide d'ondes (70).

**Fig. 1 (Stand der Technik)**

## Fig. 2 (Stand der Technik)

## Fig. 3 (Stand der Technik)

Fig. 4 (Stand der Technik)

**Fig. 5**

**Fig. 6**

**Fig. 7**

**Fig. 8**

**Fig. 9**

**Fig. 10**

**Fig. 11**

**Fig. 12**

**Fig. 13**

**Fig. 14**

**Fig. 15**

**Fig. 16**

**Fig. 17**

Fig. 18

**Fig. 19**

**Fig. 20**

# IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0984535 B1
- US 4328469 A
- US 20030007766 A1
- US 20040017836 A1
- US 20080144691 A1
- US 20020141582 A1
- US 5982804 A
- JP 2001024275 A
- US 20070002914 A1
- US 6301283 B1
- US 20030007719 A1

**In der Beschreibung aufgeführte Nicht-Patentliteratur**

- **M. FUKUDA.** *Semiconductor Lasers and LEDs,* 134-136
- **C. FIEBIG et al.** High-Power DBR-Tapered Laser at 980 nm for Single-Path Second Harmonie Generation. *IEEE J. of Selected Topics in Quantum Electronics,* Mai 2009, (15, No. 3), 978-983
- **H. WENZEL et al.** Fundamental-Lateral Mode Stabilized High-Power-Ridge Waveguide Lasers With a Low Beam Divergence. *IEEE Phot. Techn. Lett.,* 01. Februar 2008, vol. 20 (3), 214-216
- **B.S. RYVKIN ; E.A. AVRUTIN.** *J. of Appl. Phys.,* 2005, vol. 97, 123103-1-123103-6
- Surface-grating-based distributed feedback lasers fabricated using nanoimprint lithography. **J. VIHERIIÄLÄ.** Semiconductor Conf. 2008, CAS 2008, Intern. IEEE, 2008